# EUROPEAN PATENT APPLICATION

(11) **EP 4 509 644 A1**
(43) Date of publication of application: **19.02.2025**
(21) Application number: 24193749.9
(22) Date of filing: 09.08.2024
(51) Int. Cl.: C30B 15/20, C30B 15/30, C30B 27/02, C30B 29/06

(54) **GUIDE CYLINDER, AND CRYSTAL GROWTH APPARATUS AND CONTROL METHOD FOR CRYSTAL GROWTH APPARATUS**

(30) Priority: 16.08.2023 CN 202311044068
(71) Applicant: Zhonghuan Advanced Semiconductor Technology Co., Ltd., Wuxi, Jiangsu 214203 (CN); Zhonghuan Advanced (Xuzhou) Semiconductor Materials Co., Ltda, Xuzhou Jiangsu 221004 (CN)
(72) Inventor: LI, Xiangyang, Wuxi, 214203 (CN); FENG, Houkun, Wuxi, 214203 (CN)
(74) Representative: Nederlandsch Octrooibureau

(57) **Abstract**

Disclosed are a guide cylinder, and a crystal growth apparatus and a control method for the crystal growth apparatus. The guide cylinder (100) includes a partition and guide device (1), a first driving device (2), and a second driving device (3); wherein the first driving device (2) is configured to drive a first part of the partition and guide device (1) to be adapted to move between an initial position and a preset position in an axial direction of a crucible (102); at the initial position, the partition and guide device (1) is positioned above a liquid surface of a silicon melt, and at the preset position, at least a part of the first part of the partition and guide device (1) is adapted to be positioned below the liquid surface of the silicon melt; and a bottom wall of the partition and guide device (1) is spaced from a bottom wall of the crucible (102), and the partition and guide device (1) partitions an internal space of the crucible (102) into a first cavity (102a) and a second cavity (102b) that are arranged at an interval in a radial direction of the crucible (102); and the second driving device (3) is configured to drive a second part of the partition and guide device (1) to rotate about a central axis of the crucible (102), so as to stir a silicon melt in the second cavity (102b). In the guide cylinder according to an embodiment of the invention, an oxygen content of the silicon melt may be reduced, and an oxygen content of a crystal rod may be reduced accordingly.

## Description

### Cross-Reference to Related Application

The present application claims priority to Chinese Patent Application No. 202311044068.5, filed to the China National Intellectual Property Administration on August 16, 2023 and entitled "Guide Cylinder, and Crystal Growth Apparatus and Control Method for Crystal Growth Apparatus".

### Technical Field

The invention relates to a technical field of crystal growth, and in particular to a guide cylinder, and a crystal growth apparatus and a control method for the crystal growth apparatus.

### Background

In the related art, the Czochralski (CZ) method is the most commonly used method during manufacturing process of monocrystalline silicon. According to the Czochralski method, polycrystalline silicon is heated and melted in a quartz crucible to form a silicon melt, and then a seed crystal is immersed in the silicon melt and rotationally pulled upwards. Silicon is solidified and crystallized at an interface between the seed crystal and the silicon melt to form a monocrystalline silicon rod. However, the quartz crucible, a type of common crucible, a part of the quartz crucible that contacts with a surface of the silicon melt will be slowly dissolved, causing a large amount of oxygen to enter the silicon melt. In consequence, an oxygen content of the crystal rod is likely to be too high.

### Summary

The invention aims to at least solve one technical problem in the prior art. In view of the above, the invention provides a guide cylinder for a crystal growth apparatus. The guide cylinder may reduce an oxygen content of a silicon melt and reduce an oxygen content of a crystal rod.

The invention further provides a crystal growth apparatus having the above guide cylinder.

The invention further provides a control method for the above crystal growth apparatus.

The guide cylinder for the crystal growth apparatus is provided according to a first embodiment of the invention. The crystal growth apparatus includes: a furnace body, the guide cylinder, and a crucible, wherein the guide cylinder and the crucible are arranged in the furnace body, the guide cylinder is coaxially arranged with the crucible, the crucible is positioned below the guide cylinder, and a silicon melt is contained in the crucible; and the guide cylinder includes: a partition and guide device, wherein the partition and guide device is formed into a ring shape; a first driving device, wherein the first driving device is configured to drive a first part of the partition and guide device to be adapted to move between an initial position and a preset position in an axial direction of the crucible, at the initial position, the partition and guide device is positioned above a liquid surface of the silicon melt, and at the preset position, at least a part of the first part of the partition and guide device is adapted to be positioned below the liquid surface of the silicon melt; and a bottom wall of the partition and guide device is spaced from a bottom wall of the crucible, the partition and guide device partitions an internal space of the crucible into a first cavity and a second cavity that are arranged at an interval in a radial direction of the crucible, and the first cavity is positioned at a radial inner side of the second cavity; and a second driving device, wherein the second driving device is configured to drive a second part of the partition and guide device to rotate about a central axis of the crucible, so as to stir a silicon melt in the second cavity.

In the guide cylinder for a crystal growth apparatus according to the embodiment of the invention, when the first driving device drives the first part of the partition and guide device to move to the preset position, the partition and guide device partitions the internal space of the crucible into the first cavity and the second cavity that are arranged at the interval in the radial direction of the crucible. In this case, the partition and guide device may block natural thermal convection between a silicon melt in the first cavity and the silicon melt in the second cavity. Therefore, the oxygen of the quartz crucible dissolved into the first cavity is prevented from entering the second cavity under the action of the natural thermal convection. Moreover, the second driving device drives the second part of the partition and guide device to rotate about the central axis of the crucible, so as to stir the silicon melt in the second cavity. Accordingly, SiO in the silicon melt is promoted to be volatilized from a surface of the silicon melt, so that an oxygen content in the silicon melt in the second cavity is reduced, the oxygen flowing to the silicon melt in the first cavity is further reduced, and an oxygen content in a crystal rod is reduced.

In some embodiments, the partition and guide device includes: a guide mechanism, wherein the guide mechanism is formed into a ring shape, and the guide mechanism is adapted to be fixedly arranged in the furnace body; a partition mechanism, wherein the partition mechanism is arranged at a radial outer side of the guide mechanism, and the partition mechanism is in sliding fit with the guide mechanism in an axial direction of the furnace body; and the first driving device is adapted to drive the partition mechanism to move between the initial position and the preset position, and at the preset position, the partition mechanism partitions the internal space of the crucible into the first cavity and the second cavity; and a stirring mechanism, wherein the stirring mechanism is arranged at a radial outer side of the partition mechanism, the stirring mechanism is in rotating fit with the partition mechanism in a circumferential direction of the partition mechanism, an orthographic projection of the stirring mechanism is positioned in the second cavity, and the second driving device is adapted to drive the stirring mechanism to rotate about the partition mechanism.

In some embodiments, the stirring mechanism is provided with a first gas flow channel, wherein the first gas flow channel is provided with a first gas inlet and a plurality of gas outlet groups that are provided at intervals in an axial direction, the first gas inlet is in communication with the first cavity, the gas outlet groups are provided on an outer peripheral wall of the stirring mechanism, and each gas outlet group includes at least one first gas outlet; and a plurality of preset positions are provided in an up-and-down direction sequentially, and at each preset position, at least one gas outlet group is adapted to be positioned above the liquid surface of the silicon melt.

In some embodiments, the partition mechanism covers the first gas inlet, the partition mechanism is provided with a second gas flow channel, and the second gas flow channel is provided with a second gas inlet and a second gas outlet; and the second gas inlet is provided on a top wall of the partition mechanism, the second gas inlet is in communication with the first cavity, the second gas outlet is provided on a side wall of the partition mechanism, and the second gas outlet is in communication with the first gas inlet.

In some embodiments, the guide mechanism includes a cylinder portion and a mounting portion, wherein the mounting portion is connected with the furnace body and is arranged at an upper end of the cylinder portion, and the mounting portion and the cylinder portion are both formed into ring shapes; and an outer peripheral wall of the cylinder portion is provided with a third gas flow channel, the third gas flow channel penetrates a bottom wall of the cylinder portion to form a third gas inlet, the third gas inlet is in communication with the first cavity, and at the preset position, the third gas flow channel is in indirect communication with the first gas inlet.

In some embodiments, the guide cylinder for the crystal growth apparatus further includes: a blocking mechanism, wherein the blocking mechanism is movably arranged on the stirring mechanism, and the blocking mechanism is configured to open the gas outlet group positioned above the liquid surface of the silicon melt and closest to the liquid surface, and block at least the gas outlet group positioned below the liquid surface of the silicon melt.

In some embodiments, each gas outlet group includes a plurality of first gas outlets provided at intervals in a circumferential direction of the stirring mechanism; the blocking mechanism includes a blocking member, wherein the blocking member sleeves the outer peripheral wall of the stirring mechanism, the blocking member is provided with a plurality of communication opening groups provided at intervals in the axial direction, each communication opening group includes a plurality of communication openings, and each communication opening corresponds to one first gas outlet; the blocking member is capable of rotating relative to the stirring mechanism in a circumferential direction; when each communication opening of the communication opening group and the first gas outlet of the corresponding gas outlet group are staggered in the circumferential direction, the blocking member blocks the gas outlet group; and when each communication opening of the communication opening group and the first gas outlet of the corresponding gas outlet group are arranged opposite to each other in a radial direction, the blocking member opens the gas outlet group.

In some embodiments, corresponding first gas outlets of the plurality of gas outlet groups are arranged opposite to each other in the axial direction, and corresponding communication openings of the plurality of communication opening groups are staggered in the circumferential direction.

In some embodiments, each of the communication openings extends into a stripe shape in the circumferential direction, and a circumferential width of axially opposite portions of two adjacent communication openings in the axial direction is greater than or equal to a circumferential width of the first gas outlet.

In some embodiments, a bottom of the stirring mechanism is provided with a partition cavity, and a bottom and a radial outer side of the partition cavity are opened; and a plurality of partition cavities are provided, and the plurality of partition cavities are arranged at even intervals in a circumferential direction of the stirring mechanism.

In some examples, the first driving device includes a first driving member and a second driving member that are in sliding fit with each other in an up-and-down direction, one end of the second driving member is connected with the first driving member, the other end of the second driving member is connected with the stirring mechanism, the first driving member and the second driving member are both formed into ring shapes, and the second driving device is configured to directly drive the first driving member to rotate.

A crystal growth apparatus is provided according to a second embodiment of the invention. The crystal growth apparatus includes: a furnace body; a crucible, wherein the crucible is arranged in the furnace body; and a guide cylinder, wherein the guide cylinder is the guide cylinder for the crystal growth apparatus according to the first embodiment of the invention, the guide cylinder is arranged in the furnace body and positioned at an upper side of the crucible, and the guide cylinder is coaxially arranged with the crucible.

In the crystal growth apparatus according to the embodiment of the invention, by employing the above guide cylinder, the oxygen content of the crystal rod may be reduced, so that the oxygen content of the crystal rod is controlled to a certain extent.

A control method for a crystal growth apparatus is provided according to a third embodiment of the invention. The crystal growth apparatus is the crystal growth apparatus according to the second embodiment of the invention; and the control method includes: after material melting is completed, moving the first part of the partition and guide device downwards to the preset position, and rotating the second part of the partition and guide device about the central axis of the crucible.

In the control method for the crystal growth apparatus according to the embodiment of the invention, by employing the above crystal growth apparatus, the oxygen content of the silicon melt may be reduced, and the oxygen content of the crystal rod may be reduced, so that the oxygen content of the crystal rod is controlled to a certain extent.

In some embodiments, the stirring mechanism is provided with the first gas flow channel, wherein the first gas flow channel is provided with the first gas inlet and the plurality of gas outlet groups that are provided at intervals in the axial direction, the first gas inlet is in communication with the first cavity, the gas outlet groups are provided on the outer peripheral wall of the stirring mechanism, and each gas outlet group includes at least one first gas outlet; and the plurality of preset positions are provided in the up-and-down direction sequentially, and at each preset position, at least one gas outlet group is adapted to be positioned above the liquid surface of the silicon melt. The control method further includes: before an equal-diameter stage, maintaining the stirring mechanism at one of the preset positions.

In some embodiments, the plurality of preset positions include a first position to an Nth position that are arranged from bottom to top sequentially, a number of gas outlet groups positioned above the liquid surface of the silicon melt is increased in a process of moving from the first position to the Nth position, and at the Nth position, all gas outlet groups are positioned above the liquid surface of the silicon melt; and the guide cylinder further includes a blocking mechanism, wherein the blocking mechanism is movably arranged on the stirring mechanism, the blocking mechanism is configured to open the gas outlet group positioned above the liquid surface of the silicon melt and closest to the liquid surface, and block at least the gas outlet group positioned below the liquid surface of the silicon melt. The control method further includes: in the equal-diameter stage, moving the crucible and the stirring mechanism upwards at a preset speed, so that the stirring mechanism sequentially passes through a second position to the Nth position.

In some embodiments, the plurality of gas outlet groups include a first gas outlet group to an Mth gas outlet group that are arranged from top to bottom sequentially, and the blocking mechanism has a first state to an Nth state. The control method further includes: before the equal-diameter stage, positioning the first gas outlet group to an (M1)th gas outlet group above the liquid surface of the silicon melt, positioning an (M1+1)th gas outlet group to the Mth gas outlet group below the liquid surface of the silicon melt, and maintaining the blocking mechanism at the first state, so as to open the (M1)th gas outlet group and block the (M1+1)th gas outlet group to the Mth gas outlet group; in the equal-diameter stage, switching the blocking mechanism to a second state to the Nth state sequentially along with movement of the stirring mechanism; moving the stirring mechanism to the second position, so that the first gas outlet group to an (M2)th gas outlet group are positioned above the liquid surface of the silicon melt, and switching the blocking mechanism to the second state, so as to open the (M2)th gas outlet group and block an (M2+1)th gas outlet group to the Mth gas outlet group; and until moving the stirring mechanism to the Nth position, so that the first gas outlet group to the Mth gas outlet group are positioned above the liquid surface of the silicon melt, and switching the blocking mechanism to the Nth state, so as to open the Mth gas outlet group; wherein 1≤M1<M2≤M, and N≤M.

In some embodiments, each gas outlet group includes a plurality of first gas outlets provided at intervals in a circumferential direction of the stirring mechanism, wherein corresponding first gas outlets of the plurality of the gas outlet groups are arranged opposite to each other in the axial direction; the blocking mechanism includes a blocking member, wherein the blocking member sleeves the outer peripheral wall of the stirring mechanism, the blocking member is provided with a plurality of communication opening groups that are provided at intervals in the axial direction, and the plurality of communication opening groups include a first communication opening group to an Mth communication opening group that are arranged from top to bottom sequentially; each communication opening group includes a plurality of communication openings, each communication opening corresponds to one first gas outlet, and corresponding communication openings of the plurality of communication opening groups are staggered in a circumferential direction, and each communication opening extends into a strip shape in the circumferential direction; the blocking member is capable of rotating relative to the stirring mechanism in the circumferential direction; a difference between numbers of gas outlet groups positioned above the liquid surface of the silicon melt at two adjacent preset positions is one; when the stirring mechanism is positioned at an nth position, circumferential ends, away from corresponding communication openings of an (n+1)th communication opening group, of communication openings of an nth communication opening group are opposite to and in communication with an nth gas outlet group; and circumferential ends, close to corresponding communication openings of the nth communication opening group, of communication openings of an (n-1)th communication opening group are opposite to and in communication to an (n-1)th gas outlet group, wherein 1<n≤N.

Some additional aspects and advantages of the invention will be set forth in the following description, and other additional aspects and advantages will be apparent from the following description or learned by practice of the invention.

### Brief Description of the Drawings

The above and/or additional aspects and advantages of the invention will become apparent and readily appreciated from the description of examples in conjunction with the accompanying drawings. In the figures:
Fig. 1 is a schematic diagram of a crystal growth apparatus (at an initial position) according to some embodiments of the invention;
Fig. 2 is a partial enlarged view of portion A shown in Fig. 1;
Fig. 3 is another schematic diagram of a crystal growth apparatus (at a preset position) according to some embodiments of the invention;
Fig. 4 is a partial enlarged view of portion B shown in Fig. 3;
Fig. 5 is a partial enlarged view of the crystal growth apparatus shown in Fig. 3;
Fig. 6 is a sectional view of a partition and guide device according to some embodiments of the invention;
Fig. 7 is a schematic expanded diagram of a blocking member according to some embodiments of the invention;
Fig. 8 is a partial enlarged view of the blocking member shown in Fig. 7; and
Fig. 9 is a bottom view of a partition and guide device according to some embodiments of the invention.

### Reference numerals:

crystal growth apparatus 200, furnace body 101, crucible 102, first cavity 102a, second cavity 102b, heater 103,
guide cylinder 100,
partition and guide device 1, communication cavity 10,
guide mechanism 11, cylinder portion 111, third gas flow channel 111a, third gas inlet 111b, third gas outlet 111c, mounting portion 112, partition mechanism 12, second gas flow channel 121, second gas inlet 121a, second gas outlet 121b, stirring mechanism 13, first gas flow channel 131, first gas inlet 131a, gas outlet group 131b, first gas outlet 131c, partition cavity 132,
first driving device 2, first driving member 21, second driving member 22,
second driving device 3, blocking mechanism 4, communication opening group 41, communication opening 41a, blocking member 42, and third driving device 5.

### Detailed Description of the Embodiments

Embodiments of the invention are described in detail below and illustratively shown in the accompanying drawings. The same or similar reference numerals denote the same or similar elements or elements having the same or similar functions throughout. The embodiments described below with reference to the accompanying drawings are illustrative and are merely intended to explain the invention, but cannot be interpreted as limiting the invention.

The following invention provides various different embodiments or instances configured to implement different structures of the invention. Components and configurations in specific instances are described below, in order to simplify the contents of the invention. Certainly, the components and configurations are merely illustrative and are not intended to limit the invention. In addition, the invention can repeat the reference numerals and/or reference letters in different instances. Such repetition is configured for simplicity and clarity and does not indicate a relation between various examples and/or configurations discussed in itself. In addition, the invention provides instances of various specific processes and materials, but those of ordinary skill in the art can recognize applications of other processes and/or use of other materials.

A guide cylinder 100 for a crystal growth apparatus 200 according to an embodiment of the invention is described below with reference to the accompanying drawings. The crystal growth apparatus 200 includes a furnace body 101, the guide cylinder 100, and a crucible 102, wherein the guide cylinder 100 and the crucible 102 are arranged in the furnace body 101, the guide cylinder 100 is coaxially arranged with the crucible 102, in other words, a central axis of the guide cylinder 100 coincides with a central axis of the crucible 102, the crucible 102 is positioned below the guide cylinder 100, and a silicon melt is contained in the crucible 102. The guide cylinder 100 is also generally called a reflector.

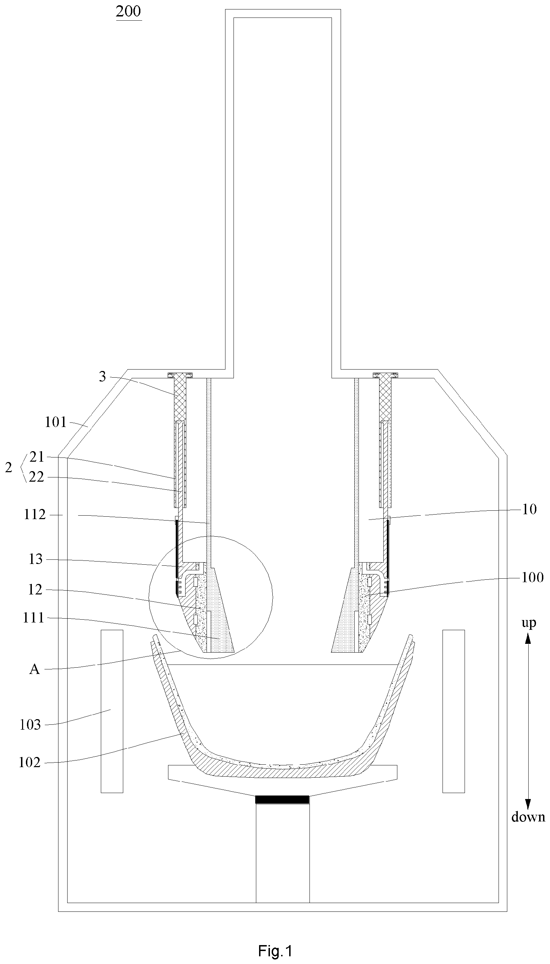

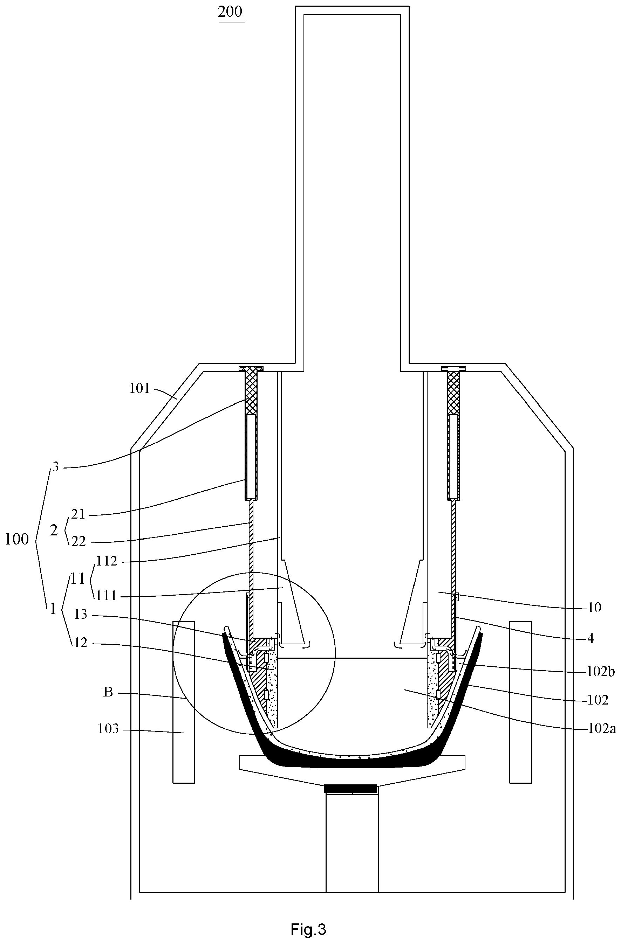

As shown in Figs. 1 and 3, the guide cylinder 100 includes a partition and guide device 1 and a first driving device 2, wherein the partition and guide device 1 is formed into a ring shape, and the first driving device 2 is configured to drive a part (such as a partition mechanism 12 and a stirring mechanism 13 described hereinafter) of the partition and guide device 1 to be adapted to move between an initial position and a preset position in an axial direction of the crucible 102.

Optionally, the ring shape is understood in a broad sense, and the ring shape may include a polygonal ring, a circular ring, or an elliptical ring, or a combination of part of a polygon and part of a circle. The ring shape corresponding to the partition and guide device 1 may be consistent with an opening shape of a containing cavity of the crucible 102 or not. For example, the ring shape corresponding to the partition and guide device 1 and the opening shape of the containing cavity of the crucible 102 are circular.

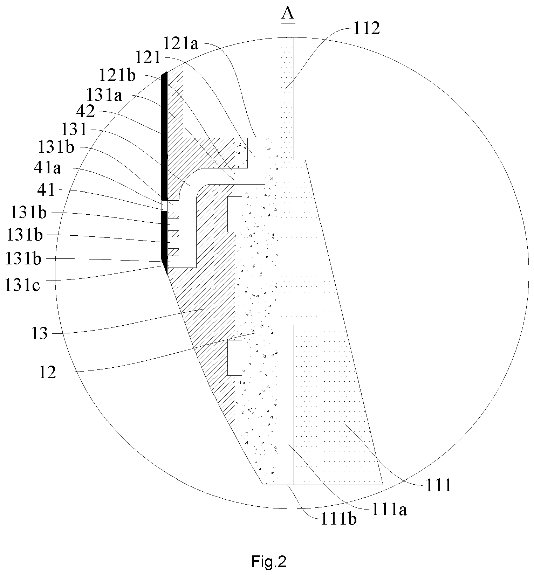

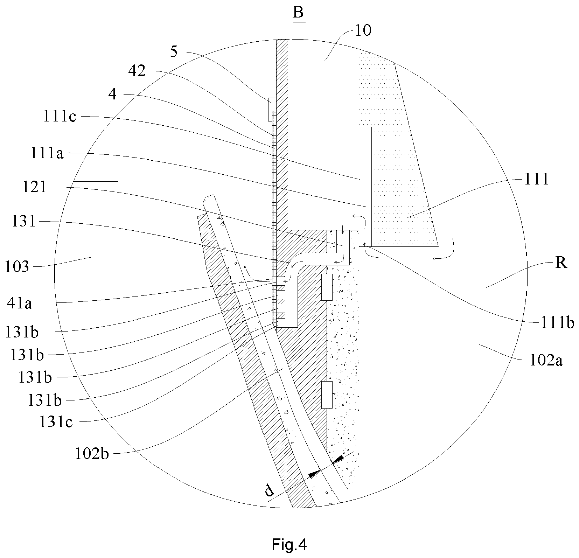

At the initial position, as shown in Figs. 1 and 2, the partition and guide device 1 is positioned above a liquid surface of the silicon melt to avoid interference between the partition and guide device 1 and the crucible 102 (for example, the partition and guide device affects melting of silicon in the crucible 102). At the preset position, as shown in Figs. 3 and 4, at least a part of the partition and guide device 1 is adapted to be positioned below the liquid surface of the silicon melt, and a bottom wall of the partition and guide device 1 is spaced from a bottom wall of the crucible 102, so as to prevent a bottom wall of a part, positioned below the liquid surface of the silicon melt, of the partition and guide device 1 from contacting with the bottom wall of the crucible 102, and avoid interference (such as friction) between the partition and guide device 1 and the crucible 102. The partition and guide device 1 positioned at the preset position partitions an internal space of the crucible 102 into a first cavity 102a and a second cavity 102b that are arranged at an interval in a radial direction of the crucible 102. The first cavity 102a is positioned at a radial inner side of the second cavity 102b. In other words, the first cavity 102a is positioned at an inner side of the partition and guide device 1, and the second cavity 102b is positioned at an outer side of the partition and guide device 1 in the radial direction of the crucible 102.

Therefore, at the preset position, the partition and guide device 1 partitions the internal space of the crucible 102 into the first cavity 102a and the second cavity 102b that are arranged at an interval, so that the partition and guide device 1 may block natural thermal convection between a silicon melt in the first cavity 102a and a silicon melt in the second cavity 102b. In other words, the partition and guide device may suppress natural thermal convection in a high-oxygen-concentration region (i.e., the second cavity 102b) near the inner wall of the crucible 102. Accordingly, the oxygen in the silicon melt in the second cavity 102b is prevented from entering the silicon melt in the first cavity 102a under the action of the natural thermal convection. An oxygen concentration of the silicon melt in the first cavity 102a may be reduced, so that an oxygen content of a crystal rod may be reduced.

It should be noted that the first cavity 102a is positioned in a central region of the internal space of the crucible 102. The crystal rod undergoes crystal growth in the central region of the crucible 102 in a crystal growth process. Therefore, the oxygen content in the crystal rod may be reduced by reducing the oxygen concentration of the silicon melt in the first cavity 102a.

In the embodiment of the invention, as shown in Figs. 3 and 4, the guide cylinder 100 further includes a second driving device 3, wherein the second driving device 3 is configured to drive another part (such as the stirring mechanism 13 described hereinafter) of the partition and guide device 1 to rotate about the central axis of the crucible 102. Therefore, the partition and guide device 1 may stir the silicon melt in the second cavity 102b, so that volatilization of dissolved oxygen from the liquid surface of the silicon melt is accelerated to reduce the oxygen content in the silicon melt. Moreover, SiO in the silicon melt is promoted to be volatilized from the surface of the silicon melt, so as to reduce a content of the SiO gas in the silicon melt in the second cavity 102b. Accordingly, the oxygen content in the silicon melt in the second cavity 102b may be reduced, the oxygen flowing to the silicon melt in the first cavity 102a may be further reduced, so that the oxygen content in the crystal rod may be reduced to control the oxygen concentration in the crystal rod.

Optionally, the crucible 102 may be a quartz crucible, a metal crucible, a graphite crucible, or a ceramic crucible, etc.

It can be understood that when the quartz crucible is used as the crucible 102, a part, contacting with the silicon melt, of the quartz crucible will be slowly dissolved (a dissolution reaction between a wall surface of the quartz crucible and the silicon melt is SiO2(s)→Si(l)+2O). Therefore, the oxygen content in the silicon melt in the region (i.e., the second cavity 102b) near the wall surface of the crucible 102 is increased. The oxygen in the high-oxygen-concentration region (i.e., the second cavity 102b) near the inner wall of the crucible 102 flows to the central region (i.e., the first cavity 102a) in the crucible 102 under the action of the natural thermal convection. Accordingly, the oxygen content in the silicon melt in the central region in the crucible 102 is increased, and most oxygen atoms transferred to the liquid surface of the silicon melt along with convection movement are volatilized in a form of SiO.

Therefore, in the invention, when the first driving device 2 drives a part of the partition and guide device 1 to move to the preset position, the partition and guide device 1 partitions the internal space of the crucible 102 into the first cavity 102a and the second cavity 102b that are arranged at an interval in the radial direction of the crucible 102. In this case, the partition and guide device 1 may block the natural thermal convection between the silicon melt in the first cavity 102a and the silicon melt in the second cavity 102b. Therefore, the oxygen dissolved into the second cavity 102b of the quartz crucible is prevented from entering the first cavity 102a under the action of the natural thermal convection. Moreover, the second driving device 3 drives the another portion of the partition and guide device 1 to rotate about the central axis of the crucible 102, so as to stir the silicon melt in the second cavity 102b. Accordingly, SiO in the silicon melt may be promoted to be volatilized from the surface of the silicon melt, so as to reduce the oxygen content in the silicon melt in the second cavity 102b, the oxygen flowing to the silicon melt in the first cavity 102a is further reduced, and the oxygen content in the crystal rod is reduced.

It can be seen that in the embodiment of the invention, the partition and guide device 1 may be provided with a first part and a second part. The first driving device 2 is configured to drive the first part to move between the initial position and the preset position in the axial direction of the crucible 102. At the initial position, the first part is positioned above the liquid surface of the silicon melt. At the preset position, the first part is at least partially adapted to be positioned below the liquid surface of the silicon melt. A bottom wall of the first part is spaced from the bottom wall of the crucible 102, so that the first part partitions the internal space of the crucible 102 into the first cavity 102a and the second cavity 102b. The second driving device 3 is configured to drive the second part to rotate about the central axis of the crucible 102. The second part may be at least part of the first part, so as to stir the silicon melt in the second cavity 102b when rotating. For example, the second part is merely part of the first part, so that when rotating under the driving of the second driving device 3, the second part positioned at the preset position stirs the silicon melt in the second cavity 102b only, instead of the silicon melt in the first cavity 102a. Accordingly, the disturbance to the liquid surface of the silicon solution in the first cavity 102a is reduced, so that the stability of the liquid surface of the silicon melt in the first cavity 102a is improved, and the crystal growth stability is improved.

In the guide cylinder 100 for the crystal growth apparatus 200 according to the embodiment of the invention, when the first driving device 2 drives a part of the partition and guide device 1 to move to the preset position, the partition and guide device 1 partitions the internal space of the crucible 102 into the first cavity 102a and the second cavity 102b that are arranged at an interval in the radial direction of the crucible 102. The partition and guide device 1 may block the natural thermal convection between the silicon melt in the first cavity 102a and the silicon melt in the second cavity 102b. Therefore, the oxygen dissolved into the second cavity 102b of the crucible 102 is prevented from entering the first cavity 102a under the action of the natural thermal convection. Moreover, the second driving device 3 drives a part of the partition and guide device 1 to rotate about the central axis of the crucible 102, so as to stir the silicon melt in the second cavity 102b. Accordingly, SiO in the silicon melt is promoted to be volatilized from the surface of the silicon melt, so as to reduce the oxygen content in the silicon melt in the second cavity 102b, the oxygen flowing to the silicon melt in the first cavity 102a is further reduced, and the oxygen content in the crystal rod is reduced.

In some embodiments, as shown in Figs. 1 and 3, the partition and guide device 1 includes a guide mechanism 11, wherein the guide mechanism 11 is formed into a ring shape, and the guide mechanism 11 is adapted to be fixedly arranged in the furnace body 101. Therefore, protective gas (such as argon) is guided to protect the crystal rod while volatile corrosive gas, etc. may be carried away, and an entire partition and guide device 1 is mounted conveniently.

The partition and guide device 1 further includes the partition mechanism 12 and the stirring mechanism 13, wherein the partition mechanism 12 is arranged at a radial outer side of the guide mechanism 11, and the partition mechanism 12 is in sliding fit with the guide mechanism 11 in an axial direction of the furnace body 101 (i.e., the axial direction of crucible 102). The first driving device 2 is adapted to drive the partition mechanism 12 to move between the initial position and the preset position. At the preset position, the partition mechanism 12 partitions the internal space of crucible 102 into the first cavity 102a and the second cavity 102b. The first cavity 102a is positioned at a radial inner side of the partition mechanism 12, and the second cavity 102b is positioned at a radial outer side of the partition mechanism 12, so that the partition mechanism 12 is also substantially ring-shaped. The partition mechanism 12 may block the natural thermal convection between the silicon melt in the first cavity 102a and the silicon melt in the second cavity 102b. The stirring mechanism 13 is arranged at the radial outer side of the partition mechanism 12, and the stirring mechanism 13 is in rotating fit with the partition mechanism 12 in a circumferential direction of the partition mechanism 12 (i.e., a circumferential direction of the guide mechanism 11). An orthographic projection of the stirring mechanism 13 is positioned in the second cavity 102b. The second driving device 3 is adapted to drive the stirring mechanism 13 to rotate about the partition mechanism 12, so as to stir the silicon melt in the second cavity 102b. Accordingly, SiO in the silicon melt is promoted to be volatilized from the surface of the silicon melt, so as to reduce the oxygen content in the silicon melt in the second cavity 102b, the oxygen flowing to the first cavity 102a is reduced, the oxygen content in the first cavity 102a is controlled, and the oxygen content in the crystal rod is reduced.

It can be seen that in the above technical solution, when the first driving device 2 drives the partition mechanism 12 to move in the axial direction, the partition mechanism 12 may drive the stirring mechanism 13 to move in the axial direction together. Accordingly, at the initial position, the partition mechanism 12 and the stirring mechanism 13 are both positioned above the liquid surface of the silicon melt. At the preset position, the partition mechanism 12 and the stirring mechanism 13 are at least partially positioned below the liquid surface of the silicon melt. The second driving device 3 may be configured to drive the stirring mechanism 13 at the preset position to rotate.

Optionally, a specific structure of the stirring mechanism 13 is not particularly limited. The stirring mechanism 13 may be formed into a ring shape and is arranged around the partition mechanism 12. Alternatively, the stirring mechanism 13 may include at least one stirring portion, wherein the stirring portion is arranged at the radial outer side of the partition mechanism 12, the stirring portion is in rotating fit with the partition mechanism 12 in the circumferential direction of the partition mechanism 12. When a plurality of stirring portions are provided, they are arranged at intervals in the circumferential direction of the partition mechanism 12.

For example, in conjunction with Fig. 2, the partition mechanism 12 and the guide mechanism 11 are both formed into ring shapes, and the partition mechanism 12 sleeves the radial outer side of the guide mechanism 11. An inner peripheral wall of the partition mechanism 12 is provided with a first sliding groove, an outer peripheral wall of the guide mechanism 11 is provided with a convex strip. The first sliding groove is in sliding fit with the convex strip in the axial direction, so that the partition mechanism 12 may slide up and down relative to the guide mechanism 11. The stirring mechanism 13 is formed into the ring shape and sleeves the partition mechanism 12. The inner peripheral wall of the stirring mechanism 13 is provided with a second sliding groove, and the outer peripheral wall of the partition mechanism 12 is provided with a sliding rail. The second sliding groove is in sliding fit with the sliding rail in the circumferential direction, so that the stirring mechanism 13 is capable of rotating relative to the partition mechanism 12 in the circumferential direction, and the stirring mechanism 13 may be in limiting fit with the partition mechanism 12 in the axial direction.

Optionally, the guide mechanism 11 may be a graphite member, etc. The partition mechanism 12 and the stirring mechanism 13 may both be silicon nitride members, etc.

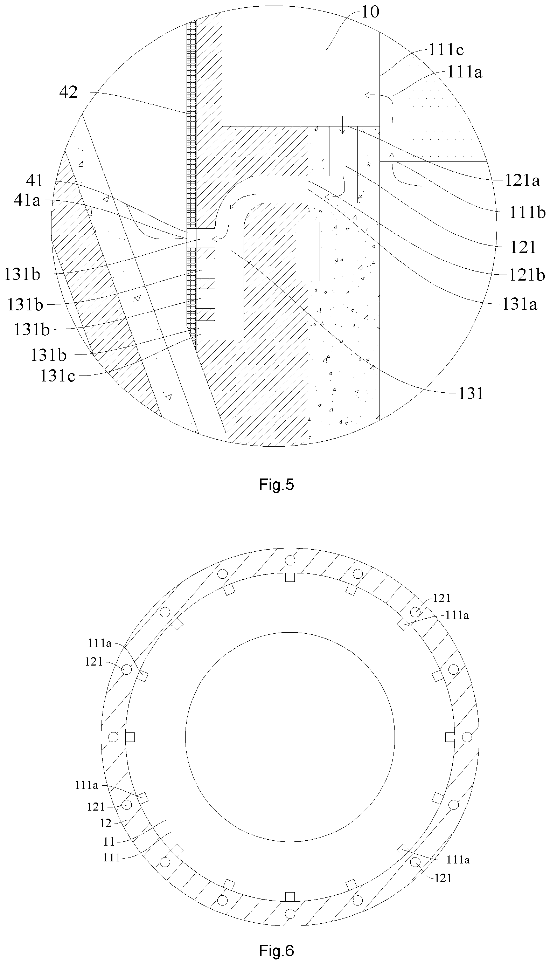

In some embodiments, as shown in Figs. 2 and 5, the stirring mechanism 13 is provided with a first gas flow channel 131, wherein the first gas flow channel 131 is provided with a first gas inlet 131a and a plurality gas outlet groups 131b that are arranged at intervals in the axial direction, the first gas inlet 131a is in communication with the first cavity 102a, the gas outlet groups 131b are provided on the outer peripheral wall of the stirring mechanism 13, and each gas outlet group 131b includes at least one first gas outlet 131c. Gas ( such as the protective gas) above a region where the first cavity 102a is positioned may flow into the first gas flow channel 131 through the first gas inlet 131a and flows to the first gas outlet 131c of corresponding gas outlet group 131b.

A plurality of preset positions are provided in an up-and-down direction sequentially. At each preset position, at least one gas outlet group 131b is adapted to be positioned above the liquid surface of the silicon melt. The gas flowing into the first gas flow channel 131 may be sent out through corresponding first gas outlet 131c of the gas outlet group 131b positioned above the liquid surface of the silicon melt and blown to the surface of the silicon melt in the second cavity 102b. Accordingly, the SiO gas volatilized from the surface of the silicon melt may be rapidly blown away, and the oxygen in the silicon melt may be promoted to be volatilized from the surface of the silicon melt in the form of SiO, so that a volatilization rate of the oxygen in the silicon melt in the second cavity 102b may be increased. Therefore, the oxygen content in the silicon melt in the second cavity 102b may be further reduced, the oxygen flowing from the second cavity 102b to the first cavity 102a may be further reduced, and the oxygen content in the crystal rod can be reduced.

It can be understood that when the partition mechanism 12 is positioned at any preset position, the corresponding gas outlet group is positioned above the liquid surface of the silicon melt. In other words, the first gas outlet 131c of the above gas outlet group 131b is positioned above the liquid surface of the silicon melt and is not immersed in the silicon melt, and the first gas outlet 131c positioned above the liquid surface of the silicon melt is spaced from the liquid surface of the silicon melt by a certain distance. Therefore, the gas flow sent out through the first gas outlet 131c may carry away SiO volatilized from the surface of the silicon melt, so that the volatilization speed of SiO in the silicon melt in the second cavity 102b is increased. The distance between the first gas outlet 131c positioned above the liquid surface of the silicon melt and the liquid surface of the silicon melt may be set specifically as demanded in practice.

It should be noted that most oxygen in the silicon melt is volatilized from the surface of the silicon melt in the form of silicon monoxide (SiO), and there is a dynamic equilibrium for volatilization of the silicon monoxide from the inside of the silicon melt to the liquid surface of the silicon melt. In the invention, by arranging the first gas flow channel 131 and positioning at least one gas outlet group above the liquid surface of the silicon melt at any preset position, the gas flow sent out through the first gas outlet 131c positioned above the liquid surface of the silicon melt may carry away the volatilized silicon monoxide. Accordingly, the oxygen in the silicon melt may be promoted to be volatilized more rapidly from the liquid surface of the silicon melt in the form of the silicon monoxide, and the oxygen content of the silicon melt in the second cavity 102b may be reduced.

For example, in the instances in Figs. 3 and 5, the stirring mechanism 13 is formed into the ring shape, the first gas flow channel 131 extends substantially into a ring shape in the circumferential direction of the stirring mechanism 13, and the first gas inlet 131a extends substantially into a ring shape, so that the first gas inlet 131a may be in communication with the first cavity 102a all the time when the stirring mechanism 13 rotates relative to the partition mechanism 12. Each gas outlet group 131b includes the plurality of first gas outlets 131c arranged at intervals in the circumferential direction. The plurality of first gas outlets 131c of the same gas outlet group 131b are positioned at the same height position in the axial direction of the stirring mechanism 13(an up-and-down direction in Fig. 3), so that the gas flow blown out through one gas outlet group 131b may be blown towards different directions individually, and the volatilization speed of SiO in the silicon melt in the second cavity 102b may be further increased. Illustratively, the plurality of first gas outlets 131c of the gas outlet group 131b are provided on an entire outer peripheral wall of the stirring mechanism 13 at intervals in the circumferential direction. When the partition mechanism 12 is moved to a certain preset position, the protective gas is sent out through the plurality of first gas outlets 131c of at least one gas outlet group 131b positioned above the liquid surface of the silicon melt, so as to rapidly carry away the silicon monoxide gas volatilized from an entire liquid surface of the silicon melt in the second cavity 102b.

In some embodiments, as shown in Figs. 1 and 2, the partition mechanism 12 covers the first gas inlet 131a, and the partition mechanism 12 is provided with at least one second gas flow channel 121, wherein the second gas flow channel 121 is provided with a second gas inlet 121a and a second gas outlet 121b, the second gas inlet 121a is provided on a top wall of the partition mechanism 12, the second gas inlet 121a is in communication with the first cavity 102a, the second gas outlet 121b is provided on a side wall of the partition mechanism 12, and the second gas outlet 121b is in communication with the first gas inlet 131a. In this way, the first gas inlet 131a may be in indirect communication with the first cavity 102a through the second gas flow channel 121. The gas in the first cavity 102a enters the second gas flow channel 121 through the second gas inlet 121a, flows to the first gas inlet 131a, then enters the first gas flow channel 131, and is finally sent out through the corresponding first gas outlet 131c.

In addition, since the second gas inlet 121a is provided on the top wall of the partition mechanism 12, when the partition mechanism 12 is moved in the axial direction under the driving of the first driving device 2, the second gas inlet 121a is unlikely to be covered by the guide mechanism 11, and the second gas inlet 121a will not be immersed in the silicon melt, causing the second gas inlet 121a to be blocked. Moreover, when the stirring mechanism 13 rotates in the circumferential direction under the driving of the second driving device 3, the second gas inlet 121a is unlikely to be covered by the stirring mechanism 13, so that the second gas inlet 121a is in communication with the first cavity 102a all the time.

Illustratively, the first gas inlet 131a is positioned on the inner peripheral wall of the stirring mechanism 13, and the partition mechanism 12 covers the inner peripheral wall of the stirring mechanism 13, so as to cover the first gas inlet 131a. The second gas outlet 121b is arranged on the outer peripheral wall of the partition mechanism 12, so as to be opposite to and in communication with the first gas inlet 131a. Alternatively, the first gas inlet 131a is positioned on the top wall of the stirring mechanism 13, the partition mechanism 12 covers the top wall of the stirring mechanism 13, so as to block the first gas inlet 131a, and the second gas outlet 121b is provided on a side wall, facing the first gas inlet 131a, of the partition mechanism 12.

Certainly, in other embodiments, the first gas inlet 131a may also be in communication with the first cavity 102a in other ways. For example, the first gas inlet 131a is positioned on the top wall of the stirring mechanism 13, and the first gas inlet 131a is not covered by the partition mechanism 12, and the first cavity 102a may be in communication with the first gas inlet 131a through a spacial region above the first cavity. For another example, the first gas inlet 131a is positioned on the inner peripheral wall of the stirring mechanism 13, and the first gas inlet 131a is not covered by the partition mechanism 12. In this case, the first cavity 102a may also be in communication with the first gas inlet 131a through the spacial region above the first cavity.

It can be understood that at least one of the first gas inlet 131a and the second gas outlet 121b extends into the ring shape in the circumferential direction. Therefore, when the stirring mechanism 13 rotates relative to the partition mechanism 12, the first gas inlet 131a is in communication with the second gas outlet 121b all the time. Accordingly, the first gas inlet 131a is in communication with the first cavity 102a all the time, so that the gas flow flows to the first gas flow channel 131 through the second gas flow channel 121 smoothly. For example, the first gas inlet 131a extends into the ring shape in the circumferential direction, and a plurality of second gas outlets 121b are provided at intervals in the circumferential direction. When the stirring mechanism 13 rotates relative to the partition mechanism 12, all the second gas outlets 121b are in communication with the first gas inlet 131a all the time. For another example, a plurality of first gas inlets 131a are provided at intervals in the circumferential direction, and the second gas outlet 121b extends into the ring shape in the circumferential direction. When the stirring mechanism 13 rotates relative to the partition mechanism 12, all the first gas inlets 131a are in communication with the second gas outlet 121b all the time. Certainly, the first gas inlets 131a and the second gas outlets 121b may also both extend into the ring shapes in the circumferential direction.

In addition, one or more second gas inlets 121a may be provided. When the plurality of second gas inlets 121a are provided, they may be provided at intervals in the circumferential direction. For example, the plurality of second gas inlets 121a and the plurality of second gas outlets 121b are provided. Each second gas inlet 121a is in communication with one second gas outlet 121b correspondingly. Alternatively, the plurality of second gas inlets 121a are provided, and one second gas outlet 121b is provided and extends into the ring shape. Each second gas inlet 121a is in communication with the above second gas outlet 121b. Alternatively, one second gas inlet 121a, and the plurality of second gas outlets 121b are provided, and the second gas inlet 121a is in communication with each second gas outlet 121b. Certainly, one second gas inlet 121a and one second gas outlet 121b may be provided. In some embodiments, the guide mechanism 11 includes a cylinder portion 111 and a mounting portion 112, wherein the mounting portion 112 is connected with the furnace body 101, the mounting portion 112 is arranged at an upper end of the cylinder portion 111, and the mounting portion 112 and the cylinder portion 111 are both formed into ring shapes. When being used for the crystal growth apparatus 200, the guide cylinder 100 may be internally provided with a closed space.

An outer peripheral wall of the cylinder portion 111 is provided with a third gas flow channel 111a, wherein the third gas flow channel 111a penetrates a bottom wall of the cylinder portion 111 to form a third gas inlet 111b, and the third gas inlet 111b is in communication with the first cavity 102a. At the preset position, the third gas flow channel 111a is in indirect communication with the first gas inlet 131a. When the partition mechanism 12 is positioned at any preset position, the third gas flow channel 111a is in indirect communication with the first gas inlet 131a.

Since the third gas flow channel 111a is arranged on the outer peripheral wall of the cylinder portion 111, the third gas flow channel 111a may be formed by denting part of the outer peripheral wall of the cylinder portion 111. In this case, a groove opening of a groove corresponding to the third gas flow channel 111a may be formed into a third gas outlet 111c. The partition mechanism 12 is movable relative to the guide mechanism 11 in the axial direction, so that part of the third gas outlet 111c may be exposed to the outside of the partition mechanism 12 without being covered by the partition mechanism 12 at any preset position by setting an axial length of the third gas outlet 111c and a movement stroke of the partition mechanism relative to the guide mechanism 11. Accordingly, the third gas flow channel 111a may be in communication with the first gas inlet 131a at any preset position.

Optionally, at the initial position, the partition mechanism 12 covers the third gas outlet 111c, so as to cover the third gas flow channel 111a. At any preset position, part of the third gas outlet 111c is exposed to the outside of the partition mechanism 12. Illustratively, in the instances in Figs. 2 and 4, an axial length of the third gas flow channel 111a approximately equal half of an axial length of the cylinder portion 111. Therefore, the third gas flow channel 111a has a sufficient length, so as to enable communication between the first cavity 102a and a communication cavity 10 at any preset position.

In some instances, as shown in Figs. 1 and 2, the partition mechanism 12 covers the first gas inlet 131a, and the partition mechanism 12 is provided with the second gas flow channel 121, and the second gas flow channel 121 is in communication with the first gas inlet 131a. In this case, at any preset position, the third gas flow channel 111a may be in indirect communication with the first gas inlet 131a through the second gas flow channel 121. Therefore, the gas in the first cavity 102a may flow to the second gas flow channel 121 through the third gas flow channel 111a, and then to the first gas flow channel 131, so that the gas flow flows from the first cavity 102a to the second cavity 102b smoothly and reliably.

In some other instances, the partition mechanism 12 does not cover the first gas inlet 131a, and the third gas flow channel 111a may be in indirect communication with the first gas inlet 131a through a spatial region positioned at the radial outer side of the guide mechanism 11 and the radial inner side of the first gas inlet 131a.

For example, in conjunction with Figs. 1 and 2, the radial outer side of the guide mechanism 11 (for example, between the guide mechanism 11 and the first driving device 2 and the second driving devices 3) is provided with the communication cavity 10, and the communication cavity 10 is adapted to enable communication between the third gas flow channel 111a and the second gas inlet 121a. The third gas flow channel 111a penetrates the bottom wall of the cylinder portion 111 to form the third gas inlet 111b, and the third gas flow channel 111a penetrates the side wall of the cylinder portion 111 to form the third gas outlet 111c. At the initial position, the partition mechanism 12 blocks the third gas outlet 111c. At any preset position, the third gas outlet 111c is in communication with the communication cavity 10, the gas in the first cavity 102a may enter the third gas flow channel 111a through the third gas inlet 111b and flow into the communication cavity 10 through the third gas outlet 111c. The communication cavity 10 is in communication with the second gas inlet 121a, and the gas flow may flow into the second gas flow channel 121 through the second gas inlet 121a and to the first gas flow channel 131. The gas in the first gas flow channel 131 is sent out through the corresponding first gas outlet 131c, so that the gas in the first cavity 102a flows to the second cavity 102b.

Certainly, in other embodiments, the cylinder portion 111 is provided with no third gas flow channel 111a, and the third gas flow channel 111a may be arranged on the mounting portion 112. In this case, the third gas flow channel 111a may enable communication between a radial inner side of the mounting portion 112 and a radial outer side of the mounting portion 112. The third gas flow channel 111a may also be in indirect communication with the first gas inlet 131a when the partition mechanism 12 is positioned at any preset position.

In some embodiments, as shown in Figs. 3 and 5, the guide cylinder 100 further includes a blocking mechanism 4, wherein the blocking mechanism 4 is movably arranged on the stirring mechanism 13, and the blocking mechanism 4 is configured to open the gas outlet group 131b positioned above the liquid surface of the silicon melt and closest to the liquid surface, so that the gas flow in the first gas flow channel 131 may be sent out through the gas outlet group 131b closest to the liquid surface. Accordingly, a distance between the gas flow blown out through the first gas outlet 131c and the liquid surface of the silicon melt is reduced, and the volatilization speed of SiO from the liquid surface of the silicon melt is further improved.

The blocking mechanism 4 is further configured to block at least the gas outlet group 131b positioned below the liquid surface of the silicon melt. At least one gas outlet group 131b is positioned below the liquid surface of the silicon melt at least one preset position. The blocking mechanism 4 may prevent the silicon melt from entering the first gas flow channel 131 through the gas outlet group 131b, so as to prevent blockage of the first gas flow channel 131 caused by the silicon melt remaining in the first gas flow channel 131. If numbers of the gas outlet groups 131b, positioned above the liquid surface of the silicon melt, corresponding to at least two of the plurality of preset positions differ, at least one gas outlet group 131b (referred to as preset gas outlet groups 131b hereinafter) is raised from below the liquid surface of the silicon melt to above the liquid surface of the silicon melt when the above at least two preset positions are switched. Accordingly, the blocking mechanism 4 may be switched from a state of blocking the preset gas outlet groups 131b to a state of opening one gas outlet group 131b, closest to the liquid surface, of the preset gas outlet groups 131b when the above at least two preset positions are switched. Therefore, the preset gas outlet groups 131b are in open without being blocked when the gas flow is required to be blown, so that the applicability of the guide cylinder 100 is improved.

Further, the blocking mechanism 4 is configured such that when plurality of gas outlet groups 131b are positioned above the liquid surface of the silicon melt, the blocking mechanism 4 also blocks remaining gas outlet groups 131b positioned above the liquid surface of the silicon melt except for the gas outlet group 131b closest to the liquid surface. Therefore, according to the blocking mechanism 4, the first gas outlets 131c of the only one gas outlet group 131b are configured to blow the gas flow at the preset position. Accordingly, the speed of the gas flow blown out through the first gas outlets 131c is improved, and the gas flow may better carry away the silicon monoxide gas volatilized from the liquid surface of the silicon melt.

For example, four gas outlet groups 131b are provided. At a certain preset position, two gas outlet groups 131b are positioned above the liquid surface of the silicon melt, and the other two gas outlet groups 131b are positioned below the liquid surface of the silicon melt. The blocking mechanism 4 is configured to block the two gas outlet groups 131b positioned below the silicon melt and the gas outlet group 131b positioned above the liquid surface of the silicon melt and at the highest position. At another preset position, three gas outlet groups 131b are positioned above the liquid surface of the silicon melt, and one remaining gas outlet group 131b is positioned below the liquid surface of the silicon melt. The blocking mechanism 4 is configured to block the one gas outlet group 131b positioned below the silicon melt and first two gas outlet groups 131b positioned above the liquid surface of the silicon melt from top to bottom.

In some embodiments, as shown in Figs. 3 and 5, the outer peripheral wall of the stirring mechanism 13 is provided with the plurality of gas outlet groups 131b that are provided at intervals in the axial direction, and each gas outlet group 131b includes the plurality of first gas outlets 131c that are provided at intervals in the circumferential direction of the stirring mechanism 13. The blocking mechanism 4 includes a blocking member 42, wherein the blocking member 42 sleeves the outer peripheral wall of the stirring mechanism 13, and the blocking member 42 is provided with a plurality of communication opening groups 41 that are provided at intervals in the axial direction. Each communication opening group 41 includes a plurality of communication openings 41a, and each communication opening 41a corresponds to one first gas outlet 131c. In other words, in the axial direction, each gas outlet group 131b corresponds to one communication opening group 41, and each gas outlet group 131b and the corresponding communication opening group 41 are positioned at the same axial height position, so that communication and non-communication between each gas outlet group 131b and the corresponding communication opening group 41 are implemented.

The blocking member 42 is capable of rotating relative to the stirring mechanism 13 in the circumferential direction. When each communication opening 41a of the communication opening group 41 and the first gas outlet 131c of the corresponding gas outlet group 131b are staggered in the circumferential direction, the blocking member 42 blocks the gas outlet group 131b. Therefore, when being positioned below the liquid surface of the silicon melt, the gas outlet group 131b is blocked by the blocking member 42, so that communication between the gas outlet group 131b and the corresponding communication opening group 41 is disabled. The blockage of the first gas flow channel 131 by the silicon melt that enters the first gas flow channel 131 through the communication opening 41a positioned below the liquid surface of the silicon melt when the partition mechanism 12 and the stirring mechanism 13 are at the preset positions is avoided. When each communication opening 41a of the communication opening group 41 is opposite to the first gas outlet 131c of the corresponding gas outlet group 131b in the radial direction, the blocking member 42 opens the gas outlet group 131b, so that the blocking member 42 may open the gas outlet group 131b when the gas outlet group 131b is positioned above the liquid surface of the silicon melt. The gas outlet group 131b is in communication with the corresponding communication opening group 41, so that the corresponding first gas outlet 131c sends out the gas flow to carry away the silicon monoxide gas volatilized from the liquid surface of the silicon melt.

It can be seen that in the above technical solution, the blocking member 42 may move in the axial direction along with the stirring mechanism 13 without changing a relative position of the blocking member 42 and the stirring mechanism 13 in the axial direction, so that a movement mode of the blocking member 42 is simplified. In addition, in the above technical solution, for the arrangement of the communication opening groups 41 and the gas outlet groups 131b, by rationally setting the relative layout method of the communication opening groups 41 and the gas outlet groups 131b, the blocking mechanism 4 may be configured such that when plurality of gas outlet groups 131b are positioned above the liquid surface of the silicon melt, the blocking mechanism 4 is further configured to block the remaining gas outlet groups 131b positioned above the liquid surface of the silicon melt except for the gas outlet group 131b closest to the liquid surface. The blocking mechanism 4 may also be configured to open all the gas outlet groups 131b positioned above the liquid surface of the silicon melt when plurality of gas outlet groups 131b are positioned above the liquid surface of the silicon melt.

For example, in the instance shown in Fig. 4, the guide cylinder 100 further includes a third driving device 5 (for example, a rotating motor), wherein the third driving device 5 is arranged on the outer peripheral wall of the stirring mechanism 13, and the third driving device 5 may drive the blocking member 42 to rotate relative to the stirring mechanism 13 in the circumferential direction, so that communication and non-communication between the communication opening groups 41 and the gas outlet groups 131b are implemented.

Certainly, the blocking mechanism 4 is not limited thereto. For example, the blocking mechanism 4 includes the blocking member 42, wherein the blocking member 42 is movable relative to the stirring mechanism 13 in the axial direction. With the liquid surface of the silicon melt as a boundary, the blocking member 42 is at least partially adapted to be arranged below the liquid surface of the silicon melt, so as to block the gas outlet groups 131b below the liquid surface of the silicon melt. In this case, the gas outlet group 131b positioned above the liquid surface of the silicon melt is not blocked by the blocking member 42. For example, the blocking member 42 extends a certain distance above the liquid surface of the silicon melt, so that when the gas outlet group 131b is moved to a position above the liquid surface of the silicon melt and spaced from the liquid surface of the silicon melt at least by a preset distance, and the blocking member 42 opens the gas outlet group 131b. Illustratively, the blocking member 42 may be fixedly arranged on the furnace body 101, so that the blocking member 42 and the stirring mechanism 13 may be moved relative to each other in the axial direction when the stirring mechanism 13 is moved along with the partition mechanism 12 in the axial direction, and it is not required to provide a separate driving device for the blocking member 42.

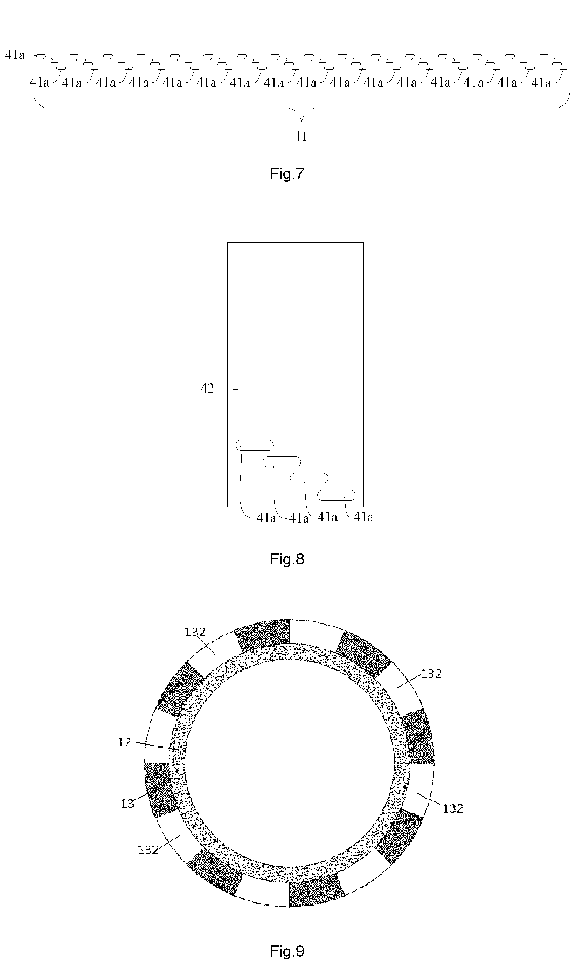

In some embodiments, as shown in Figs. 5 and 7, corresponding first gas outlets 131c of the plurality of gas outlet groups 131b are arranged opposite to each other in the axial direction. Therefore, corresponding first gas outlets 131c of any two adjacent gas outlet groups 131b are arranged opposite to each other in the axial direction. The corresponding first gas outlets 131c of the plurality of gas outlet groups 131b are arranged into a plurality of rows at intervals in the circumferential direction, and a plurality of first gas outlets 131c in each row are arranged opposite to each other in the axial direction. Corresponding communication openings 41a of the plurality of communication opening groups 41 are staggered in the circumferential direction, that is, corresponding communication openings 41a of any two adjacent communication opening groups 41 are staggered in the circumferential direction. Therefore, centers of the corresponding communication openings 41a of any two adjacent communication opening groups 41 are arranged at intervals in the circumferential direction. It can be seen that plurality of corresponding communication openings 41a that are provided at intervals in the axial direction may be formed into one row. The row of the communication openings 41a corresponds to a row of first gas outlets 131c, and a plurality of rows of communication openings 41a are arranged at intervals in the circumferential direction.

Therefore, the blocking member 42 is capable of rotating relative to the stirring mechanism 13 in the circumferential direction, so that the blocking member 42 may open the gas outlet group 131b positioned above the liquid surface of the silicon melt and closest to the liquid surface while blocking the gas outlet groups 131b positioned below the liquid surface of the silicon melt.

For example, in the instances in Figs. 5 and 7, the outer peripheral wall of the stirring mechanism 13 is provided with the four gas outlet groups 131b that are arranged at intervals in the axial direction (the up-and-down direction in Fig. 3), each gas outlet group 131b is provided with the plurality of first gas outlets 131c arranged at intervals in the circumferential direction, numbers of the first gas outlets 131c of the plurality of gas outlet groups 131b are the same. The corresponding first gas outlets 131c of any two adjacent gas outlet groups 131b are arranged opposite to each other in the axial direction, so that the four corresponding first gas outlets 131c are provided at intervals into one row in the axial direction. Each row of the first gas outlets 131c includes a first first gas outlet 131c, a second first gas outlet 131c, a third first gas outlet 131c, and a fourth first gas outlet 131c in sequence from top to bottom. The plurality of first first gas outlets 131c that are arranged at intervals in the circumferential direction constitute a first gas outlet group 131b. The plurality of second first gas outlets 131c that are arranged at intervals in the circumferential direction constitute a second gas outlet group 131b. The plurality of third first gas outlets 131c that are arranged at intervals in the circumferential direction constitute a third gas outlet group 131b. The plurality of fourth first gas outlets 131c that are arranged at intervals in the circumferential direction constitute a fourth gas outlet group 131b.

The blocking member 42 is arranged on the radial outer side of the stirring mechanism 13, and the blocking member 42 is provided with four communication opening groups 41 that are arranged at intervals in the axial direction. Each communication opening group 41 includes the plurality of communication openings 41a that are arranged at intervals in the circumferential direction. A number of the communication openings 41a of a single communication opening group 41 equals a number of the first gas outlets 131c of a single gas outlet group 131b. The corresponding communication openings 41a of the two communication opening groups 41 are staggered sequentially in the circumferential direction to form one row of communication openings 41a. Each row of communication openings 41a includes a first communication opening 41a, a second communication opening 41a, a third communication opening 41a, and a fourth communication opening 41a from top to bottom sequentially. The plurality of first communication openings 41a that are arranged at intervals in the circumferential direction constitute a first communication opening group 41. The plurality of second communication openings 41a that are arranged at intervals in the circumferential direction constitute a second communication opening group 41. The plurality of third communication openings 41a that are arranged at intervals in the circumferential direction constitute a third communication opening group 41. The plurality of fourth communication openings 41a that are arranged at intervals in the circumferential direction constitute a fourth communication opening group 41.

When each row of the first gas outlets 131c is positioned between two adjacent rows of the communication openings 41a, the blocking member 42 blocks all the first gas outlets 131c. In this case, each first gas outlet 131c and the corresponding communication opening 41a are arranged at an interval in the circumferential direction. The blocking member 42 rotates relative to the stirring mechanism 13 in the circumferential direction. The first first gas outlet 131c of each row of the first gas outlets 131c is in communication with the first communication opening 41a of each row of the communication openings 41a, and the gas flow in the first gas flow channels 131 is sent out through the plurality of first first gas outlets 131c of the first gas outlet group 131b. As the blocking member 42 continues rotating relative to the stirring mechanism 13 in the circumferential direction, the second first gas outlet 131c of each row of the first gas outlets 131c is in communication with the second communication opening 41a of each row of the communication openings 41a, and the gas flow in the first gas flow channels 131 is sent out through the plurality of second first gas outlets 131c of the second gas outlet group 131b. Then, the third first gas outlet 131c of each row of the first gas outlets 131c is in communication with the third communication opening 41a of each row of the communication openings 41a, and the gas flow in the first gas flow channels 131 is sent out through the plurality of third first gas outlets 131c of the third gas outlet group 131b. Finally, the fourth first gas outlet of each row of the first gas outlets 131c is in communication with the fourth communication opening 41a of each row of the communication openings 41a, and the gas flow in the first gas flow channels 131 is sent out through the plurality of fourth first gas outlets 131c of the fourth gas outlet group 131b. In this case, the crystal growth apparatus 200 may complete an equal-diameter stage of the crystal rod.

Certainly, the number of the gas outlet groups 131b and the number of the communication opening groups 41 are not limited thereto. For example, two, three, five, or more groups may be provided.

In some embodiments, as shown in Figs. 5 and 8, each of the communication openings 41a extends into a strip shape in the circumferential direction, and a circumferential width of axially opposite portions of two adjacent communication openings 41a in the axial direction is greater than or equal to a circumferential width of the first gas outlet 131c. When the blocking member 42 rotates relative to the stirring mechanism 13 in the circumferential direction, in a transition process from communication between one of the two adjacent communication openings 41a and the corresponding first gas outlet 131c to communication between the other one of the two adjacent communication openings 41a and the corresponding first communication opening 41a, the axially opposite portions of the two adjacent communication openings 41a are in communication with the two corresponding first gas outlets 131c respectively. Therefore, at least one communication opening 41a keeps in communication with the corresponding first gas outlet 131c all the time in the above transition process of the two adjacent communication openings 41a. A communication area between the communication openings 41a and the corresponding first gas outlets 131c is changed within a small range, without being changed abruptly when the blocking member 42 rotates relative to a stirring mechanism in the circumferential direction.

Illustratively, two adjacent communication openings 41a in the axial direction are staggered in the circumferential direction, and two adjacent communication openings 41 are axially opposite to each other on the sides close to each other in the circumferential direction and are staggered from each other on the sides away from each other in the circumferential direction. With the two adjacent communication openings 41a in the axial direction being the first communication opening 41a and the second communication opening 41a as an example, when the blocking member 42 rotates relative to the stirring mechanism in the circumferential direction, a staggered portion, relative to the second communication opening 41a, of the first communication opening 41a is opposite to and in communication with the corresponding first gas outlet 131c. In this case, the second communication opening 41a is staggered with and is not in communication with the corresponding first gas outlet 131c. As the blocking member 42 continues rotating relative to the stirring mechanism 13 in the circumferential direction until the axially opposite portion, relative to the second communication opening 41a, of the first communication opening 41a is opposite to and in communication with the corresponding first gas outlet 131c, and the axially opposite portion, relative to the first communication opening 41a, of the second communication opening 41a is also opposite to and in communication with the corresponding first gas outlet 131c. The blocking member 42 continues rotating relative to the stirring mechanism 13, so that the communication area between the first communication opening 41a and the corresponding first gas outlet 131c is reduced until the first communication opening 41a is staggered with and is not in communication with the corresponding first gas outlet 131c. In this case, a staggered portion, relative to the first communication opening 41a, of the second communication opening 41a is opposite to and in communication with the corresponding first gas outlet 131c. Therefore, in a process of transitioning from a state in which the first communication opening 41a is in communication with the corresponding first gas outlet 131c, and the second communication opening 41a is not in communication with the corresponding first gas outlet 131c to a state in which the second communication opening 41a is in communication with the corresponding first gas outlet 131c, and the first communication opening 41a is not in communication with the corresponding first gas outlet 131c, the communication area between the communication openings 41a and the first gas outlets 131c is unlikely to be changed abruptly, so that the stability of the gas flow sent out through the first gas flow channel 131 via the first gas outlet is ensured.

In some embodiments, as shown in Fig. 9, a bottom of the stirring mechanism 13 is provided with a partition cavity 132, a bottom and a radial outer side of the partition cavity 132 are opened, a plurality of partition cavities 132 are provided, and the plurality of partition cavities 132 are arranged at even intervals in the circumferential direction of the stirring mechanism 13. At any preset position, the silicon melt in the second cavity 102b may flow to the partition cavities 132, so that a contact area between the stirring mechanism 13 and the silicon melt at any preset position may be increased. In addition, a shape of a contact surface between the stirring mechanism 13 and the silicon melt at any preset position is more complicated. Accordingly, the stirring mechanism 13 may better stir the silicon melt in the second cavity 102b, so that a stirring effect is improved, and the silicon monoxide in the silicon melt in the second cavity 102b is promoted to be volatilized.

For example, the partition cavities 132 may be formed by denting part of the outer peripheral wall of the stirring mechanism 13, so that cavity walls of the partition cavities 132 and remaining outer peripheral wall of the stirring mechanism 13 are not positioned on the same cylindrical surface. A specific shape of the partition cavities 132 is not particularly limited.

In some embodiments, as shown in Figs. 1 and 3, the first driving device 2 includes a first driving member 21 and a second driving member 22 that are in sliding fit with each other in the up-and-down direction, wherein one end of the second driving member 22 is connected with the first driving member 21, the other end of the second driving member 22 is connected with the stirring mechanism 13, and the first driving member 21 and the second driving member 22 are both formed into ring shapes. The second driving device 3 is configured to directly drive the first driving member 21 to rotate.

Therefore, the second driving member 22 is movable relative to the first driving member 21 in the axial direction, so as to drive the stirring mechanism 13 to move in the axial direction. The stirring mechanism 13 drives the partition mechanism 12 to move in the axial direction together, so that the partition mechanism 12 is switched between the initial position and the preset position. In addition, the second driving device 3 drives the first driving member 21 to rotate, so as to drive the second driving member and the stirring mechanism to rotate, so that the stirring mechanism 13 stirs the silicon melt in the second cavity 102b.

In the description of the invention, "the axial direction" indicates the axial direction of the crucible 102, the axial direction of the guide cylinder 100, the axial direction of the partition and guide device 1, and the axial direction of the furnace body 101. The "circumferential direction" indicates the circumferential direction of the crucible 102, the circumferential direction of the guide cylinder 100, the circumferential direction of the partition and guide device 1, and the circumferential direction of the furnace body 101. The "radial direction" indicates the radial direction of the crucible 102, the radial direction of the guide cylinder 100, the radial direction of the partition and guide device 1, and the radial direction of the furnace body 101.

A crystal growth apparatus 200 is provided according to a second embodiment of the invention. The crystal growth apparatus includes a furnace body 101, a crucible 102, and a guide cylinder 100, wherein the crucible 102 is arranged in the furnace body 101, the guide cylinder 100 is the guide cylinder 100 for the crystal growth apparatus 200 according to the first embodiment of the invention, the guide cylinder 100 is arranged in the furnace body 101 and positioned at an upper side of the crucible 102, and the guide cylinder 100 is coaxially arranged with the crucible 102.

In the crystal growth apparatus 200 according to the embodiment of the invention, by employing the above guide cylinder 100, the oxygen content of the crystal rod may be reduced, so that the oxygen content of the crystal rod is controlled to a certain extent.

In some embodiments, as shown in Fig. 1, the crystal growth apparatus 200 further includes a heater 103, wherein the heater 103 is formed into a ring shape and arranged around the crucible 102, and the crucible 102 is arranged coaxially with the heater 103, so that the heating uniformity in the crucible 102 is ensured.

A control method for a crystal growth apparatus 200 is provided according to a third embodiment of the invention. The crystal growth apparatus 200 is the crystal growth apparatus 200 according to the second embodiment of the invention. The control method includes: after material melting is completed, moving the part of the partition and guide device 1 downwards to the preset position, and rotating the part of the partition and guide device 1 about the central axis of a crucible 102.

For example, after material melting is completed, the silicon melt is contained in the crucible 102. The first driving device 2 drives the part of the partition and guide device 1 to move to the preset position in the axial direction, so that the part of the partition and guide device 1 is positioned below the liquid surface of the silicon melt. In the above process, a liquid surface position of the silicon melt is changed, and thus it is required to make the part of the partition and guide device 1 positioned below a current liquid surface of the silicon melt at the preset position. Therefore, natural thermal convection between the silicon melt in the first cavity 102a and the silicon melt in the second cavity 102b is blocked, and oxygen dissolved into the second cavity 102b of the crucible 102 is prevented from entering the first cavity 102a under the action of the natural thermal convection. Then, the second driving device 3 drives the part of the partition and guide device 1 to rotate about the central axis of the crucible 102, so as to stir the silicon melt in the second cavity 102b. Accordingly, the oxygen and SiO in the silicon melt are promoted to be the volatilized from the surface of the silicon melt, so as to reduce the oxygen content in the silicon melt in the second cavity 102b.

In the control method for the crystal growth apparatus 200 according to the embodiment of the invention, by employing the above crystal growth apparatus 200, the oxygen content of the silicon melt may be reduced, and the oxygen content of the crystal rod may be reduced, so that the oxygen content of the crystal rod is controlled to a certain extent.

It can be understood that before material melting and during material melting, the part of the partition and guide device 1 is positioned at the initial position, and the partition and guide device 1 is positioned above the current liquid surface of the silicon melt.

It can be understood that in the control logic, the action that the part of the partition and guide device 1 rotates about the central axis of the crucible 102 may be started after material melting is completed. Duration of the action is not particularly limited. For example, the action may be maintained until an initial equal-diameter stage, a middle equal-diameter stage, or an end equal-diameter stage, which are known to those skilled in the art and will not be repeated herein.

In some embodiments, in conjunction with Figs. 5 and 7, the stirring mechanism 13 is provided with the first gas flow channel 131, wherein the first gas flow channel 131 is provided with the first gas inlet 131a and the plurality of gas outlet groups 131b that are provided at intervals in the axial direction, the first gas inlet 131a is in communication with the first cavity 102a, the gas outlet groups 131b are provided on the outer peripheral wall of the stirring mechanism 13, and each gas outlet group 131b includes at least one first gas outlet 131c. The plurality of preset positions are provided in the up-and-down direction sequentially, and at each preset position, at least one gas outlet group 131b is adapted to be positioned above the liquid surface of the silicon melt. The control method further includes: before the equal-diameter stage, maintaining the stirring mechanism 13 at one of the preset positions, so that the stirring mechanism 13 does not affect the liquid surface position of the silicon melt before the equal-diameter stage, so as to prevent the stirring mechanism 13 from affecting growth of the crystal rod before the equal-diameter stage, and the growth stability of the crystal rod before the equal-diameter stage is ensured.

For example, before the equal-diameter stage, it includes a seeding phase, a shoulder expanding phase, a shoulder turning phase, a shoulder releasing phase, etc. The stirring mechanism 13 is maintained at the corresponding preset position in preparation for stirring the silicon melt in the second cavity 102b in the equal-diameter stage.

It can be understood that before the equal-diameter stage, the stirring mechanism 13 and the partition mechanism 12 are maintained at one preset position. The preset position is adapted to a height position of the crucible 102 in the crystal growth apparatus 200. Accordingly, the bottom wall of the stirring mechanism 13 and the bottom wall of the partition mechanism 12 are spaced from the bottom wall of the crucible 102 by a distance d, wherein 3cm≤d≤5cm. For example, d may be 3 cm, 4 cm, or 5 cm. When the plurality of preset positions are provided, a plurality of corresponding distances may be the same or not.

In some embodiments, in conjunction with Figs. 5 and 7, the plurality of preset positions include a first position to an Nth position that are arranged from bottom to top sequentially, a number of gas outlet groups 131b positioned above the liquid surface of the silicon melt is increased in a process of moving from the first position to the Nth position. At the Nth position, all the gas outlet groups 131b are positioned above the liquid surface of the silicon melt. Therefore, the stirring mechanism 13 and the partition mechanism 12 are moved upwards together from the first position, so as to increase the number of the gas outlet groups 131b positioned above the liquid surface of the silicon melt, until the stirring mechanism 13 and the partition mechanism 12 are moved to the Nth position. In this case, all the gas outlet groups 131b are positioned above the liquid surface of the silicon melt.

Optionally, when the stirring mechanism 13 and the partition mechanism 12 are moved to the Nth position, the crystal rod may enter an ending phase from the equal-diameter stage.

The guide cylinder 100 further includes the blocking mechanism 4, wherein the blocking mechanism 4 is movably arranged on the stirring mechanism 13, and the blocking mechanism 4 is configured to open the gas outlet group 131b positioned above the liquid surface of the silicon melt and closest to the liquid surface, and block at least the gas outlet group 131b positioned below the liquid surface of the silicon melt, so that first gas outlets 131c of the gas outlet group 131b closest to the liquid surface may blow the gas flow, so as to carry away silicon monoxide volatilized from the liquid surface of the silicon melt in the second cavity 102b. Moreover, the blocking member 42 blocks the gas outlet group 131b positioned below the liquid surface of the silicon melt, so as to prevent blockage of the first gas outlets 131c or the first gas flow channel 131 by the silicon melt that enters the first gas outlets 131c of the corresponding gas outlet group 131b.

Illustratively, when opening the gas outlet group 131b positioned above the liquid surface of the silicon melt and closest to the liquid surface, the blocking mechanism 4 blocks the gas outlet group 131b positioned at an upper side of the gas outlet group 131b positioned above the liquid surface and closest to the liquid surface and blocks the gas outlet group 131b positioned below the liquid surface of the silicon melt. In other words, the blocking member 42 opens the gas outlet group 131b positioned above the liquid surface of the silicon melt and closest to the liquid surface only, so that the gas flow in the first gas flow channel 131 is sent out only through first gas outlets 131c of the gas outlet group 131b closest to the liquid surface. Therefore, the gas flow at the first corresponding gas outlets 131c has a sufficient gas flow speed to more rapidly carry away the silicon monoxide volatilized from the liquid surface of the silicon melt.

In addition, the control method further includes: in the equal-diameter stage, moving the crucible 102 and the stirring mechanism 13 upwards at a preset speed, so that the stirring mechanism 13 passes through a second position to the Nth position sequentially. Before the equal-diameter stage, the preset position where the stirring mechanism 13 is positioned is the first position, and moreover, an absolute height position of the liquid surface of the silicon melt remains unchanged. In other words, the liquid surface position, relative to the guide mechanism 11, of the silicon melt remains unchanged, so that the liquid surface of the silicon melt is stable, and the growth stability of crystal rod is improved. Moreover, since the crucible 102 and the stirring mechanism 13 are moved upwards at the same speed, the bottom wall of the part, positioned below the liquid surface of the silicon melt, of the partition and guide device 1 is spaced from the bottom wall of the crucible 102 by a proper distance all the time, so that interference between the partition and guide device 1 and the crucible 102 is avoided. In this case, for the plurality of preset positions, distances between the bottom wall of the part, positioned below the liquid surface of the silicon melt, of the partition and guide device 1 and the bottom wall of the crucible 102 are the same.

In some embodiments, in conjunction with Figs. 5 and 7, the plurality of gas outlet groups 131b include a first gas outlet group to an Mth gas outlet group that are provided from top to bottom sequentially, and the blocking mechanism 4 has a first state to an Nth state. The control method further includes:
before the equal-diameter stage, positioning the first gas outlet group to an (M1)th gas outlet group above the liquid surface of the silicon melt, positioning an (M1+1)th gas outlet group to the Mth gas outlet group below the liquid surface of the silicon melt, and maintaining the blocking mechanism 4 at the first state, so as to open the (M1)th gas outlet group and block the (M1+1)th gas outlet group to the Mth gas outlet group. In this case, the (M1)th gas outlet group is the group, closest to the liquid surface, of the gas outlet groups 131b positioned above the liquid surface of the silicon melt, and the (M1+1)th gas outlet group to the Mth gas outlet group are positioned below the liquid surface of the silicon melt. In this case, the stirring mechanism 13 and the partition mechanism 12 are maintained at the first position.

It can be understood that before the equal-diameter stage, when the stirring mechanism 13 and the partition mechanism 12 are positioned at the first position, the blocking member 42 is maintained at the first state. In this case, the (M1)th gas outlet group may be a first gas outlet group, a second gas outlet group, or a third gas outlet group, etc., and 1≤M1. The blocking member 42 may be adapted to the liquid surface height of the crucible 102, so as to ensure that the (M1)th gas outlet group is the group, closest to the liquid surface, of the gas outlet groups 131b positioned above the liquid surface of the silicon melt at the first position. In other words, when M1=1, only the first gas outlet group is positioned above the liquid surface of the silicon melt. When M1>1, the first gas outlet group to the M1 gas outlet group are positioned above the liquid surface of the silicon melt.

Illustratively, when M1>1, before the equal-diameter stage, the blocking mechanism 4 also blocks the first gas outlet group to an (M1-1)th gas outlet group. When M1=1, the blocking mechanism 4 blocks the second gas outlet group to the Mth gas outlet group before the equal-diameter stage.

In the equal-diameter stage, switching the blocking mechanism 4 to the second state to the Nth state sequentially along with movement of the stirring mechanism 13. For example, the blocking mechanism 4 includes the blocking member 42, and the blocking member 42 is rotatable relative to the stirring mechanism 13 in the circumferential direction, so as to implement state switch of the blocking mechanism 4. In the equal-diameter stage, the blocking member 42 moves along with the stirring mechanism 13 and rotates relative to the stirring mechanism 13, so that the blocking mechanism 4 is sequentially switched to the second state to the Nth state. Therefore, the blocking mechanism 4 may open the gas outlet group 131b positioned above liquid surface of the silicon melt and closest to the liquid surface at any preset position, and block at least the gas outlet group 131b positioned below the liquid surface of the silicon melt at any preset position simultaneously.

Moving the stirring mechanism 13 to the second position, so that the first gas outlet group to an (M2)th gas outlet group are positioned above the liquid surface of the silicon melt, and an (M2+1)th gas outlet group to the Mth gas outlet group are positioned below the liquid surface of the silicon melt. And switching the blocking mechanism 4 to the second state, so as to open the (M2)th gas outlet group and block the (M2+1)th gas outlet group to the Mth gas outlet group. In this case, first gas outlets 131c of the (M2)th gas outlet group are in communication with the first gas flow channel 131, and the gas flow is sent out through the corresponding first gas outlets 131c and blown to the liquid surface of the silicon melt, where 1≤M1<M2≤M.

Illustratively, when the stirring mechanism 13 is moved to the second position, the blocking mechanism 4 also blocks the first gas outlet group to the (M2-1)th gas outlet group, so that the gas flow in the first gas flow channel 131 is blown only through the (M2)th gas outlet group. The stirring mechanism 13 is finally moved to the Nth position, so that the first gas outlet group to the Mth gas outlet group are positioned above the liquid surface of the silicon melt, and the blocking member 42 is switched to the Nth state, so as to open the Mth gas outlet group, wherein 2≤N≤M. Illustratively, when the stirring mechanism 13 is moved to the Nth position, the blocking mechanism 4 blocks the first gas outlet group to the (M-1)th gas outlet group 131b, so that the gas flow in the first gas flow channel 131 is blown only through the Mth gas outlet group.

Therefore, between completion of material melting and the equal-diameter stage, the blocking mechanism 4 may be switched to a corresponding state along with the movement of the stirring mechanism 13, so that the state of the blocking mechanism 4 matches the position of the stirring mechanism 13. Therefore, the partition and guide device 1 may block the natural thermal convection between the first cavity 102a and the second cavity 102b. The first gas outlets 131c of the gas outlet group 131b positioned above the liquid surface of the silicon melt and closest to the liquid surface is maintained to blow gas to the second cavity 102b, so as to carry away the silicon monoxide volatilized from the liquid surface of the silicon melt in the second cavity 102b. Accordingly, the silicon monoxide is promoted to be volatilized from the liquid surface of the silicon melt, the oxygen content of the silicon melt is reduced, and the oxygen content of the crystal rod is reduced.

It can be understood that a difference between numbers of gas outlet groups 131b positioned above the liquid surface of the silicon melt corresponding to two adjacent preset positions may be 1 or greater than 1. For example, the difference is 2 or 3, etc. When three or more preset positions are provided, the differences between numbers of gas outlet groups 131b positioned above the liquid surface of the silicon melt corresponding to any two adjacent preset positions may be same or not. For example, with three preset positions as an example, the difference between the numbers of the gas outlet groups 131b positioned above the liquid surface of the silicon melt corresponding to any two adjacent preset positions is 1. Alternatively, the difference between the numbers of the gas outlet groups 131b positioned above the liquid surface of the silicon melt corresponding to two adjacent preset positions is 1, and the difference between the numbers of the gas outlet groups 131b positioned above the liquid surface of the silicon melt corresponding to another two adjacent preset positions is 2.

In other words, when the stirring mechanism 13 is moved upwards to a next preset position, and the blocking member 42 is switched to a next state, one, or two, or more gas outlet groups 131b may be additionally positioned above the liquid surface of the silicon melt. When the difference between the numbers of the gas outlet groups 131b positioned above the liquid surface of the silicon melt corresponding to at least two adjacent preset positions is greater than 1, M>N.

For example, in conjunction with Figs. 5 and 7, with M1=1, M2=2, and M=N=4 as an example, the blocking mechanism 4 includes the blocking member 42, wherein the blocking member 42 is rotatable relative to the stirring mechanism 13, the four preset positions include a first position, a second position, a third position, and a fourth position that are arranged from bottom to top sequentially, and the four gas outlet groups 131b include a first gas outlet group, a second gas outlet group, a third gas outlet group, and a fourth gas outlet group that are provided from top to bottom sequentially. Before the equal-diameter stage, the stirring mechanism 13 and the partition mechanism 12 are positioned at the first position, and only the first gas outlet group is positioned above the liquid surface of the silicon melt. In this case, the blocking member 42 is positioned in the first state, so as to open the first gas outlet group and block the second gas outlet group to the fourth gas outlet group. In the equal-diameter stage, the stirring mechanism 13, the partition mechanism 12, and the crucible 102 are raised at the preset speed, and the stirring mechanism 13 and the partition mechanism 12 are moved from the first position to the second position. In this case, the first gas outlet group and the second gas outlet group are positioned above the liquid surface of the silicon melt, and the third gas outlet group and the fourth gas outlet group are positioned below the liquid surface of the silicon melt. The blocking member 42 is rotated relative to the stirring mechanism 13 at a preset rotation speed to be switched from the first state to the second state, so as to block the first gas outlet group, the third gas outlet group, and the fourth gas outlet group, and open the second gas outlet group. Then, the stirring mechanism 13, the partition mechanism 12, and the crucible 102 continue being raised at the preset speed, the blocking member 42 continues being rotated relative to the stirring mechanism 13 at the preset rotation speed, and the stirring mechanism 13 and the partition mechanism 12 are moved from the second position to the third position. In this case, the first gas outlet group to the third gas outlet group are positioned above the liquid surface of the silicon melt, and the fourth gas outlet group is positioned below the liquid surface of the silicon melt. The blocking member 42 is switched from the second state to a third state, so as to block the first gas outlet group, the second gas outlet group, and the fourth gas outlet group, and open the third gas outlet group. Then, the stirring mechanism 13, the partition mechanism 12, and the crucible 102 continue being raised at the preset speed, the blocking member 42 continues being rotated relative to the partition mechanism 12 at the preset rotation speed, and the stirring mechanism 13 and the partition mechanism 12 are moved from the third position to a fourth position. In this case, the first gas outlet group to the fourth gas outlet group are positioned above the liquid surface of the silicon melt, and the blocking member 42 is switched from the third state to a fourth state, so as to block the first gas outlet group to the third gas outlet group, and open the fourth gas outlet group.

In some embodiments, in conjunction with Figs. 5 and 7, each gas outlet group 131b includes a plurality of first gas outlets 131c that are arranged at intervals in the circumferential direction of the stirring mechanism 13, and corresponding first gas outlets 131c of the plurality of gas outlet groups 131b are arranged opposite to each other in the axial direction. The blocking mechanism 4 includes the blocking member 42, wherein the blocking member 42 sleeves the outer peripheral wall of the stirring mechanism 13, the blocking member 42 is provided with a plurality of communication opening groups 41 that are arranged at intervals in the axial direction, and the plurality of communication opening groups 41 include a first communication opening group to an Mth communication opening group that are arranged from top to bottom sequentially. Each communication opening group 41 includes a plurality of communication openings 41a, each communication opening 41a corresponds to one first gas outlet 131c, and corresponding communication openings 41a of the plurality of communication opening groups 41 are staggered in the circumferential direction, and each communication opening 41a extends into a strip shape in the circumferential direction. The blocking member 42 is rotatable relative to the stirring mechanism 13 in the circumferential direction.

The difference between the numbers of the gas outlet groups 131b positioned above the liquid surface of the silicon melt at two adjacent preset positions is 1. In this case, if one gas outlet group 131b is positioned above the liquid surface of the silicon melt at the first position, M may equal N.

When the stirring mechanism 13 is positioned at an nth position, circumferential ends, away from corresponding communication openings 41a of an (n+1)th communication opening group, of communication openings 41a of an nth communication opening group are opposite to and in communication with an nth gas outlet group 131b; and circumferential ends, close to corresponding communication openings 41a of the nth communication opening group, of communication openings 41a of an (n-1)th communication opening group are opposite to and in communication with an (n-1)th gas outlet group, wherein 1<n≤N. Therefore, the blocking member 42 is gradually and stably switched from the state corresponding to the nth position in which the nth gas outlet group and the (n-1)th gas outlet group are opened to the state in which the blocking member 42 opens the nth gas outlet group only. When the blocking member 42 is positioned in the state in which only the nth gas outlet group is opened, the stirring mechanism 13 is positioned between the nth position and the (n+1)th position. When the stirring mechanism 13 is sequentially moved from the first position to the nth position, the first communication opening group to the nth communication opening group of the blocking member 42 are sequentially opposite to and in communication with the first gas outlet group to the nth gas outlet group 131b. When the nth gas outlet group 131b is in communication with the nth communication opening group, the nth gas outlet group 131b is the group, closest to the liquid surface, of the gas outlet groups 131b positioned above the liquid surface of the silicon melt.

For example, in conjunction with Figs. 5 and 7, with n=2 and N=4 as an example, when the stirring mechanism 13 is positioned at the second position, circumferential ends, away from the corresponding communication openings 41a of the third communication opening group, of the communication openings 41a of the second communication opening group are opposite to and in communication with the second gas outlet group 131b, and circumferential ends, close to the corresponding communication openings 41a of the second communication opening group, of the communication openings 41a of the first communication opening group are opposite to and in communication with the first gas outlet group 131b. Therefore, the blocking member 42 opens the first gas outlet group and the second gas outlet group and blocks the third gas outlet group and the fourth gas outlet group, so that the blocking member 42 is gradually and stably switched from the above state to the state in which the blocking member 42 opens the second gas outlet group only. When the blocking member 42 is positioned in the state in which only the second gas outlet group is opened, the stirring mechanism 13 is positioned between the second position and the third position. With n=3 as an example, when the stirring mechanism 13 is at the third position, circumferential ends, away from the corresponding communication openings 41a of the fourth communication opening group, of the communication openings 41a of the third communication opening group are opposite to and in communication with the third gas outlet group 131b, and circumferential ends, close to the corresponding communication openings 41a of the third communication opening group, of the communication openings 41a of the second communication opening group are opposite to and in communication with the second gas outlet group 131b. Therefore, the blocking member 642 opens the second gas outlet group and the third gas outlet group and blocks the first gas outlet group and the fourth gas outlet group, so that the blocking member 42 is gradually and stably switched from the above state to the state in which the blocking member 42 opens the third gas outlet group only.

A control process for the crystal growth apparatus 200 according to a specific embodiment of the invention is described below with reference to Figs. 1-8.

As shown in Figs. 1-8, the crystal growth apparatus 200 includes a furnace body 101, a crucible 102, and a guide cylinder 100, wherein the crucible 102 and the guide cylinder 100 are arranged in the furnace body 101, the guide cylinder 100 is arranged at an upper side of the crucible 102, the guide cylinder 100 is coaxially arranged with the crucible 102, and a silicon melt is contained in the crucible 102. The guide cylinder 100 includes a partition and guide device 1, a first driving device 2, and a second driving device 3. The partition and guide device 1 includes a guide mechanism 11, a partition mechanism 12, a stirring mechanism 13, and a blocking mechanism 4, wherein the guide mechanism 11, the partition mechanism 12, the stirring mechanism 13, and the blocking mechanism 4 are all formed into ring shapes, the guide mechanism 11 is fixedly arranged in the furnace body 101, the partition mechanism 12 is arranged at a radial outer side of the guide mechanism 11, and the partition mechanism 12 is in sliding fit with the guide mechanism 11 in an up-and-down direction; the stirring mechanism 13 is arranged at a radial outer side of the partition mechanism 12, and the stirring mechanism 13 is in sliding fit with the partition mechanism 12 in a circumferential direction; the blocking mechanism 4 includes a blocking member 42, wherein the blocking member 42 is formed into a ring shape, the blocking member 42 is arranged at a radial outer side of the stirring mechanism 13, an outer peripheral wall of the stirring mechanism 13 is provided with a third driving device 5, the third driving device 5 is positioned at an upper side of the blocking member 42, and the third driving device 5 drives the blocking member 42 to rotate relative to the stirring mechanism 13 in the circumferential direction; two ends of the second driving device 3 are connected with the furnace body 101 and the first driving device 2 respectively, and the other end of the first driving device 2 is connected with the stirring mechanism 13; and the first driving device 2 may drive the partition mechanism 12, the stirring mechanism 13, and the blocking mechanism 4 to move in the up-and-down direction, and the second driving device 3 may drive the stirring mechanism 13 to rotate relative to the partition mechanism 12 in the circumferential direction through the first driving device 2.

The guide mechanism 11 includes a cylinder portion 111 and a mounting portion 112, wherein the mounting portion 112 is connected with the furnace body 101 and arranged at an upper end of the cylinder portion 111. An outer peripheral wall of the cylinder portion 111 is provided with sixteen third gas flow channels 111a that are arranged at even intervals in the circumferential direction of the cylinder portion 111. Each third gas flow channel 111a penetrates a bottom wall of the cylinder portion 111 to form a third gas inlet 111b. Each third gas flow channel 111a penetrates a side wall of the cylinder portion 111 to form a third gas outlet 111c, and an axial length of the third gas flow channel 111a equals half of an axial length of the cylinder portion 111. A communication cavity 10 is formed between the guide mechanism 11 and the first driving device 2 as well as the second driving device 3. The partition mechanism 12 is provided with sixteen second gas flow channels 121 that are arranged at even intervals in the circumferential direction of the partition mechanism 12. Each second gas flow channel 121 is provided with a second gas inlet 121a that is positioned at an upper end of the partition mechanism 12, the second gas inlet 121a is in communication with the communication cavity 10, each second gas flow channel 121 is provided with a second gas outlet 121b that is positioned on the outer peripheral wall of the partition mechanism 12, and the second gas flow channels 121 are arranged opposite to the third gas flow channels 111a in the radial direction. The stirring mechanism 13 is provided with a first gas flow channel 131, the first gas flow channel 131 is provided with a first gas inlet 131a that is positioned on an inner peripheral wall of the stirring mechanism 13, the first gas inlet 131a is in communication with all second gas outlets 121b, and the first gas flow channel 131 is provided with four gas outlet groups 131b that are arranged at intervals in the axial direction and positioned on the outer peripheral wall of the stirring mechanism 13. The four gas outlet groups 131b include a first gas outlet group, a second gas outlet group, a third gas outlet group, and a fourth gas outlet group that are arranged from top to bottom sequentially. Each gas outlet group 131b includes sixteen first gas outlets 131c that are arranged at even intervals in the circumferential direction of the stirring mechanism 13. The first gas flow channel 131 enables communication between the first gas inlet 131a and the four gas outlet groups 131b, and the corresponding first gas outlets 131c of the four gas outlet groups 131b are opposite to each other in the axial direction, so that the first gas outlets 131c of the four gas outlet groups 131b are formed into sixteen rows in the circumferential direction of the partition mechanism 12. The blocking member 42 is provided with four communication opening groups 41 that are arranged at intervals in the axial direction, and the four communication opening groups 41 include a first communication opening group, a second communication opening group, a third communication opening group, and a fourth communication opening group 41 that are arranged from top to bottom sequentially. Each communication opening group 41 includes sixteen communication openings 41a that are arranged at even intervals in the circumferential direction of the blocking member 42, and each communication opening 41a extends into a strip shape in the circumferential direction of the blocking member 42. The corresponding communication openings 41a of the four communication opening groups 41 are staggered from top to bottom in the axial direction sequentially, so that four adjacent communication openings 41a are formed substantially into a stepped shape. Two adjacent communication openings 41a have opposite portions in the axial direction, and a circumferential width of the opposite portions equals a circumferential width of the first gas outlets 131c. The four communication opening groups 41 are arranged corresponding to the four gas outlet groups 131b in the axial direction respectively. When the blocking member 42 rotates relative to the stirring mechanism 13 in the circumferential direction, the four communication opening groups 41a are in communication with the corresponding gas outlet groups 131b in the circumferential direction respectively.

The first driving device 2 may drive the partition mechanism 12, the stirring mechanism 13, and the blocking mechanism 4 to move between an initial position and a preset position in the axial direction of the crucible 102. At the initial position, the partition and guide device 1 is positioned above a liquid surface of the silicon melt. At the preset position, the partition mechanism 12, the stirring mechanism 13, and the blocking mechanism 4 are at least partially positioned below the liquid surface of the silicon melt, and a bottom wall of the partition mechanism 12 and a bottom wall of the stirring mechanism 13 are spaced from a bottom wall of the crucible 102. The partition mechanism 12 partitions an internal space of the crucible 102 into a first cavity 102a and a second cavity 102b that are arranged at an interval in the radial direction of the crucible 102, the first cavity 102a is positioned at a radial inner side of the second cavity 102b, so that the partition mechanism 12 may block natural thermal convection between a silicon melt in the first cavity 102a and a silicon melt in the second cavity 102b, and the silicon melt having a high oxygen content in the second cavity 102b is prevented from flowing to the first cavity 102a. At any preset position, the second driving device 3 drives the stirring mechanism 13 to rotate relative to the partition mechanism 12 in the circumferential direction, so as to stir the silicon melt in the second cavity 102b. Therefore, the solubility of dissolved oxygen may be reduced, and dissolved oxygen and silicon monoxide may be promoted to be volatilized from a free surface of the silicon melt, so that the oxygen content of the silicon melt in the second cavity 102b is reduced, and the oxygen flowing from the second cavity 102b to the first cavity 102a is reduced.

The third gas inlets 111b are in communication with the first cavity 102a. At any preset position, the third gas outlets 111c are in communication with the communication cavity 10, so that protective gas in the first cavity 102a may enter the third gas flow channels 111a through the third gas inlets 111b and flow into the communication cavity 10 through the third gas outlets 111c. Then, the protective gas enters the second gas flow channels 121 through the second gas inlets 121a and flows to the first gas inlet 131a through the second gas outlets 121b. The gas flow flows into the first gas flow channel 131 through the first gas inlet 131a and to the corresponding gas outlet group 131b. The partition mechanism 12 is provided with four preset positions. The four preset positions include a first position, a second position, a third position, and a fourth position that are arranged from bottom to top sequentially. A difference of numbers of gas outlet groups 131b positioned above the liquid surface of the silicon melt at two adjacent preset positions is 1. At the fourth position, all the gas outlet groups 131b are positioned above the liquid surface of the silicon melt.

A specific control process is as follows:
1. After material melting in the crucible 102 is completed, the third driving device 5 drives the blocking member 42 to rotate forwards relative to the stirring mechanism 13 in the circumferential direction, so that ends, away from the second communication opening group in the circumferential direction, of the communication openings 41a of the first communication opening group are opposite to and in communication with the first gas outlets 131c of the first gas outlet group, the blocking member 42 opens the first gas outlet group only, and the gas flow is sent out through the first gas outlets 131c of the first gas outlet group. The first driving device 2 drives the partition mechanism 12, the stirring mechanism 13, and the blocking mechanism 4 to move downwards until the partition mechanism 12 is moved to the first position. In this case, a distance between a bottom wall of the partition mechanism 12 as well as a bottom wall of the stirring mechanism 13 and a bottom wall of the crucible 102 is between 3 cm and 5 cm, and only the first gas outlet group is positioned above the liquid surface of the silicon melt in the second cavity 102b.
2. The second driving device 3 drives the stirring mechanism 13 to rotate relative to the partition mechanism 12 in the circumferential direction, so as to stir the silicon melt in the second cavity 102b.
3. In the seeding phase, the shoulder expanding phase, the shoulder turning phase, and the shoulder releasing phase, height positions of the partition mechanism 12 and the stirring mechanism 13 in the up-and-down direction remain unchanged, and the second driving device 3 may continuously drive the stirring mechanism 13 to rotate, so as to stir the silicon melt in the second cavity 102b.
4. In the equal-diameter stage, the crystal growth apparatus 200 lifts the crucible 102 upwards at the preset speed, and the first driving device 2 drives the partition mechanism 12, the stirring mechanism 13, and the blocking mechanism 4 to move upwards at the preset speed simultaneously, so that the distance between the bottom wall of the partition mechanism 12 as well as the bottom wall of the stirring mechanism 13 and the bottom wall of the crucible 102 remains unchanged. Moreover, the third driving device 5 drives the blocking member 42 to rotate forwards relative to the stirring mechanism 13 in the circumferential direction at the preset rotation speed. When the partition mechanism 12 is moved upwards from the first position to the second position, the second gas outlet group is higher than the liquid surface of the silicon melt by 2 cm, ends, away from the third communication opening group in the circumferential direction, of the communication openings 41a of the second communication opening group are opposite to and in communication with the first gas outlets 131c of the second gas outlet group, the blocking member 42 opens the first gas outlet group and the second gas outlet group, and the gas flow may be sent out through the first gas outlets 131c of the second gas outlet group and the first gas outlets of the first gas outlet group. As the equal-diameter stage continues, ends, close to the third communication opening group in the circumferential direction, of the communication openings 41a of the second communication opening group are opposite to and in communication with the first gas outlets 131c of the second gas outlet group. In this case, the blocking member 42 opens the second gas outlet group only and blocks the first gas outlet group, the third gas outlet group, and the fourth gas outlet group. When the partition mechanism 12 is moved upwards from the second position to the third position, the third gas outlet group is higher than the liquid surface of the silicon melt by 2 cm, ends, away from the fourth communication opening group 41 in the circumferential direction, of the communication openings 41a of the third communication opening group are opposite to and in communication with the first gas outlets 131c of the third gas outlet group, the blocking member 42 opens the third gas outlet group and the second gas outlet group and blocks the first gas outlet group and the fourth gas outlet group, and the gas flow is sent out through the first gas outlets 131c of the third gas outlet group and the first gas outlets of the second gas outlet group. As the equal-diameter stage continues, ends, close to the fourth communication opening group in the circumferential direction, of the communication openings 41a of the third communication opening group are opposite to and in communication with the first gas outlets 131c of the third gas outlet group. In this case, the blocking member 42 opens the third gas outlet group only and blocks the first gas outlet group, the second gas outlet group, and the fourth gas outlet group. When the partition mechanism 12 is moved upwards from the third position to the fourth position, the fourth gas outlet group is higher than the liquid surface of the silicon melt by 2 cm, ends, close to the third communication opening group in the circumferential direction, of the communication openings 41a of the fourth communication opening group 41 are opposite to and in communication with the first gas outlets 131c of the fourth gas outlet group, the blocking member 42 opens the third gas outlet group and the fourth gas outlet group and blocks the first gas outlet group and the second gas outlet group, and the gas flow is sent out through the first gas outlets 131c of the third gas outlet group and the first gas outlets of the fourth gas outlet group. It can be understood that when the partition mechanism 12 is moved from the first position to the fourth position, the crystal growth apparatus 200 completes the equal-diameter stage of crystal rod growth. In the above process, the crucible 102, the partition mechanism 12, and the stirring mechanism 13 are synchronously, continuously, and stably raised at the same speed, and the liquid surface of the silicon melt drops in the crucible 102 so that the number of gas outlet groups 131b located above the liquid surface increases. Moreover, the blocking member 42 is adapted to rotate continuously, so as to match rising of the partition mechanism 12 and the stirring mechanism 13.
5. The ending phase is entered when the equal-diameter stage is completed, the crystal growth apparatus 200 stops lifting the crucible 102 upwards, the first driving device 2 stops driving the partition mechanism 12, the stirring mechanism 13, and the blocking mechanism 4 to move upwards, and the third driving device 5 stop driving the blocking member 42 to rotate. In this case, ends, away from the third communication opening group in the circumferential direction, of the communication openings 41a of the fourth communication opening group 41 are opposite to and in communication with the first gas outlets 131c of the fourth gas outlet group. Therefore, the blocking member 42 opens the fourth gas outlet group only and blocks the first gas outlet group to the third gas outlet group. Therefore, the crystal growth apparatus 200 completes a crystal growth process of the crystal rod.

In the description of the invention, it should be understood that the orientation or position relations indicated by the terms "center", "length", "width", "thickness", "up", "down", "front", "rear", "top", "bottom", "inner", "outer", "in an axial direction", "in a radial direction", "in a circumferential direction" etc. are based on the orientation or position relations shown in the accompanying drawings, are merely for facilitating the description of the invention and simplifying the description, rather than indicating or implying that the device or element referred to must have a particular orientation or be constructed and operated in a particular orientation, and therefore cannot be interpreted as limiting the invention. In addition, the features defined with "first" and "second" can explicitly or implicitly include one or more features. In the description of the invention, "a plurality of" indicates two or more unless otherwise specified.

In the description of the invention, it should be noted that the terms "mount", "connect", and "connection" should be understood in a broad sense, for example, they can denote a fixed connection, a detachable connection, an integrated connection, a mechanical connection, an electrical connection, a direct connection, an indirect connection via an intermediate medium, or communication inside two elements, unless otherwise explicitly specified and defined. For those of ordinary skill in the art, the specific meanings of the above terms in the invention can be understood according to specific circumstances.

In the description of the invention, the descriptions with reference to the terms "an embodiment", "some embodiments", "an illustrative embodiment", "an instance", "a specific instance", or "some instances", etc. mean that a specific feature, structure, material, or characteristic described in connection with the embodiment or instance falls within at least one embodiment or instance of the description. In the description, the illustrative expressions of the above terms do not indicate the same embodiments or instances necessarily. Moreover, the specific feature, structure, material, or characteristic described can be combined in any one or more embodiments or instances in a suitable way.

While the embodiments of the invention have been shown and described, it can be understood by those of ordinary skill in the art that various changes, modifications, substitutions, and variations can be made to these embodiments without departing from the principles and spirit of the invention, and the scope of the invention is defined by the claims and their equivalents.

## Claims

1. A guide cylinder for a crystal growth apparatus, wherein the crystal growth apparatus (200) comprises: a furnace body (101), the guide cylinder (100), and a crucible (102), wherein the guide cylinder (100) and the crucible (102) are arranged in the furnace body (101), the guide cylinder (100) is coaxially arranged with the crucible (102), the crucible (102) is positioned below the guide cylinder (100), and a silicon melt is contained in the crucible (102); and the guide cylinder (100) comprises:
a partition and guide device (1), wherein the partition and guide device (1) is formed into a ring shape;
a first driving device (2), wherein the first driving device (2) is configured to drive a first part of the partition and guide device (1) to be adapted to move between an initial position and a preset position in an axial direction of the crucible (102), at the initial position, the partition and guide device (1) is positioned above a liquid surface of the silicon melt, and at the preset position, at least a part of the first part of the partition and guide device (1) is adapted to be positioned below the liquid surface of the silicon melt; and a bottom wall of the partition and guide device (1) is spaced from a bottom wall of the crucible (102), the partition and guide device (1) partitions an internal space of the crucible (102) into a first cavity (102a) and a second cavity (102b) that are arranged at an interval in a radial direction of the crucible (102), and the first cavity (102a) is positioned at a radial inner side of the second cavity (102b); and
a second driving device (3), wherein the second driving device (3) is configured to drive a second part of the partition and guide device (1) to rotate about a central axis of the crucible (102), so as to stir a silicon melt in the second cavity (102b).

2. The guide cylinder for the crystal growth apparatus according to claim 1, wherein the partition and guide device (1) comprises:
a guide mechanism (11), wherein the guide mechanism (11) is formed into a ring shape, and the guide mechanism (11) is adapted to be fixedly arranged in the furnace body (101);
a partition mechanism (12), wherein the partition mechanism (12) is arranged at a radial outer side of the guide mechanism (11), and the partition mechanism (12) is in sliding fit with the guide mechanism (11) in an axial direction of the furnace body (101); and the first driving device (2) is adapted to drive the partition mechanism (12) to move between the initial position and the preset position, and at the preset position, the partition mechanism (12) partitions the internal space of the crucible (102) into the first cavity (102a) and the second cavity (102b); and
a stirring mechanism (13), wherein the stirring mechanism (13) is arranged at a radial outer side of the partition mechanism (12), the stirring mechanism (13) is in rotating fit with the partition mechanism (12) in a circumferential direction of the partition mechanism (12), an orthographic projection of the stirring mechanism (13) is positioned in the second cavity (102b), and the second driving device (3) is adapted to drive the stirring mechanism (13) to rotate about the partition mechanism (12).

3. The guide cylinder for the crystal growth apparatus according to claim 2, wherein the stirring mechanism (13) is provided with a first gas flow channel (131), the first gas flow channel (131) is provided with a first gas inlet (131a) and a plurality of gas outlet groups (131b) that are arranged at intervals in an axial direction, the first gas inlet (131a) is in communication with the first cavity (102a), the gas outlet groups (131b) are provided on an outer peripheral wall of the stirring mechanism (13), and each gas outlet group (131b) comprises at least one first gas outlet (131c); and
a plurality of preset positions are provided in an up-and-down direction sequentially, and at each preset position, at least one gas outlet group (131b) is adapted to be positioned above the liquid surface of the silicon melt.

4. The guide cylinder for the crystal growth apparatus according to claim 3, wherein the partition mechanism (12) covers the first gas inlet (131a), the partition mechanism (12) is provided with a second gas flow channel (121), and the second gas flow channel (121) is provided with a second gas inlet (121a) and a second gas outlet (121b); and the second gas inlet (121a) is provided on a top wall of the partition mechanism (12), the second gas inlet (121a) is in communication with the first cavity (102a), the second gas outlet (121b) is provided on a side wall of the partition mechanism (12), and the second gas outlet (121b) is in communication with the first gas inlet (131a).

5. The guide cylinder for the crystal growth apparatus according to claim 3, wherein the guide mechanism (11) comprises a cylinder portion (111) and a mounting portion (112), the mounting portion (112) is connected with the furnace body (101) and is arranged at an upper end of the cylinder portion (111), and the mounting portion (112) and the cylinder portion (111) are both formed into ring shapes; and
an outer peripheral wall of the cylinder portion (111) is provided with a third gas flow channel (111a), the third gas flow channel (111a) penetrates a bottom wall of the cylinder portion (111) to form a third gas inlet (111b), the third gas inlet (111b) is in communication with the first cavity (102a), and at the preset position, the third gas flow channel (111a) is in indirect communication with the first gas inlet (131a).

6. The guide cylinder for the crystal growth apparatus according to claim 3, further comprising:
a blocking mechanism (4), wherein the blocking mechanism (4) is movably arranged on the stirring mechanism (13), and the blocking mechanism (4) is configured to open the gas outlet group (131b) positioned above the liquid surface of the silicon melt and closest to the liquid surface, and block at least the gas outlet group (131b) positioned below the liquid surface of the silicon melt; wherein each gas outlet group (131b) comprises a plurality of first gas outlets (131c) that are provided at intervals in a circumferential direction of the stirring mechanism (13);
the blocking mechanism (4) comprises a blocking member (42), wherein the blocking member (42) sleeves the outer peripheral wall of the stirring mechanism (13), the blocking member (42) is provided with a plurality of communication opening groups (41) that are provided at intervals in the axial direction, each communication opening group (41) comprises a plurality of communication openings (41a), and each communication opening (41a) corresponds to one first gas outlet (131c);
the blocking member (42) is capable of rotating relative to the stirring mechanism (13) in a circumferential direction; when each communication opening (41a) of the communication opening group (41) and the first gas outlet (131c) of the corresponding gas outlet group (131b) are staggered in the circumferential direction, the blocking member (42) blocks the gas outlet group (131b); and when each communication opening (41a) of the communication opening group (41) and the first gas outlet (131c) of the corresponding gas outlet group (131b) are arranged opposite to each other in a radial direction, the blocking member (42) opens the gas outlet group (131b).

7. The guide cylinder for the crystal growth apparatus according to claim 6, wherein corresponding first gas outlets (131c) of the plurality of gas outlet groups (131b) are arranged opposite to each other in the axial direction, and corresponding communication openings (41a) of the plurality of communication opening groups (41) are staggered in the circumferential direction; each of the communication openings (41a) extends into a stripe shape in the circumferential direction, and a circumferential width of axially opposite portions of two adjacent communication openings (41a) in the axial direction is greater than or equal to a circumferential width of the first gas outlet (131c).

8. The guide cylinder for the crystal growth apparatus according to claim 2, wherein a bottom of the stirring mechanism (13) is provided with a partition cavity (132), and a bottom and a radial outer side of the partition cavity (132) are opened; and a plurality of partition cavities (132) are provided, and the plurality of partition cavities (132) are arranged at even intervals in a circumferential direction of the stirring mechanism (13).

9. The guide cylinder for the crystal growth apparatus according to any one of claims 1-8, wherein the first driving device (2) comprises a first driving member (21) and a second driving member (22) that are in sliding fit with each other in an up-and-down direction, one end of the second driving member (22) is connected with the first driving member (21), the other end of the second driving member (22) is connected with the stirring mechanism (13), the first driving member (21) and the second driving member (22) are both formed into ring shapes, and the second driving device (3) is configured to directly drive the first driving member (21) to rotate.

10. A crystal growth apparatus, comprising:
a furnace body (101);
a crucible (102), wherein the crucible (102) is arranged in the furnace body (101); and
a guide cylinder (100), wherein the guide cylinder (100) is the guide cylinder for the crystal growth apparatus according to any one of claims 1-9, the guide cylinder (100) is arranged in the furnace body (101) and positioned at an upper side of the crucible (102), and the guide cylinder (100) is coaxially arranged with the crucible (102).

11. A control method for a crystal growth apparatus, wherein the crystal growth apparatus (200) is the crystal growth apparatus according to claim 10; and the control method comprises:
after material melting is completed, moving the first part of the partition and guide device (1) downwards to the preset position, and rotating the second part of the partition and guide device (1) about the central axis of the crucible (102).

12. The control method for the crystal growth apparatus according to claim 11, wherein the guide cylinder (100) is the guide cylinder for the crystal growth apparatus according to any one of claims 3-7; and the control method further comprises:
before an equal-diameter stage, maintaining the stirring mechanism (13) at one of the preset positions.

13. The control method for the crystal growth apparatus according to claim 12, wherein the plurality of preset positions comprise a first position to an Nth position that are arranged from bottom to top sequentially, a number of gas outlet groups (131b) positioned above the liquid surface of the silicon melt is increased in a process of moving from the first position to the Nth position, and at the Nth position, all gas outlet groups (131b) are positioned above the liquid surface of the silicon melt;
the guide cylinder (100) further comprises a blocking mechanism (4), wherein the blocking mechanism (4) is movably arranged on the stirring mechanism (13), the blocking mechanism (4) is configured to open the gas outlet group (131b) positioned above the liquid surface of the silicon melt and closest to the liquid surface, and block at least the gas outlet group (131b) positioned below the liquid surface of the silicon melt; and
the control method further comprises:
in the equal-diameter stage, moving the crucible (102a) and the stirring mechanism (13) upwards at a preset speed, so that the stirring mechanism (13) sequentially passes through a second position to the Nth position.

14. The control method for the crystal growth apparatus according to claim 13, wherein the plurality of gas outlet groups (131b) comprise a first gas outlet group to an Mth gas outlet group that are arranged from top to bottom sequentially, and the blocking mechanism (4) has a first state to an Nth state; and
the control method further comprises:
before the equal-diameter stage, positioning the first gas outlet group to an (M1)th gas outlet group above the liquid surface of the silicon melt, positioning an (M1+1)th gas outlet group to the Mth gas outlet group below the liquid surface of the silicon melt, and maintaining the blocking mechanism (4) at the first state, so as to open the (M1)th gas outlet group and block the (M1+1)th gas outlet group to the Mth gas outlet group;
in the equal-diameter stage, switching the blocking mechanism (4) to a second state to the Nth state sequentially along with movement of the stirring mechanism (13);
moving the stirring mechanism (13) to the second position, so that the first gas outlet group to an (M2)th gas outlet group are positioned above the liquid surface of the silicon melt, and switching the blocking mechanism (4) to the second state, so as to open the (M2)th gas outlet group and block an (M2+1)th gas outlet group to the Mth gas outlet group; and
until moving the stirring mechanism (13) to the Nth position, so that the first gas outlet group to the Mth gas outlet group are positioned above the liquid surface of the silicon melt, and switching the blocking mechanism (4) to the Nth state, so as to open the Mth gas outlet group; wherein
1≤M1<M2≤M, and N≤M.

15. The control method for the crystal growth apparatus according to claim 14, wherein each gas outlet group (131b) comprises a plurality of first gas outlets (131c) that are provided at intervals in a circumferential direction of the stirring mechanism (13), and corresponding first gas outlets (131c) of the plurality of gas outlet groups (131b) are arranged opposite to each other in the axial direction;
the blocking mechanism (4) comprises a blocking member (42), wherein the blocking member (42) sleeves the outer peripheral wall of the stirring mechanism (13), the blocking member (42) is provided with a plurality of communication opening groups (41) that are provided at intervals in the axial direction, and the plurality of communication opening groups (41) comprise a first communication opening group to an Mth communication opening group that are arranged from top to bottom sequentially; each communication opening group (41) comprises a plurality of communication openings (41a), each communication opening (41a) corresponds to one first gas outlet (131c), and corresponding communication openings (41a) of the plurality of communication opening groups (41) are staggered in a circumferential direction, and each communication opening (41a) extends into a strip shape in the circumferential direction; the blocking member (42) is capable of rotating relative to the stirring mechanism (13) in the circumferential direction;
a difference between numbers of gas outlet groups (131b) positioned above the liquid surface of the silicon melt at two adjacent preset positions is one;
when the stirring mechanism (13) is positioned at an nth position, circumferential ends, away from corresponding communication openings (41a) of an (n+1)th communication opening group, of communication openings (41a) of an nth communication opening group are opposite to and in communication with an nth gas outlet group; and circumferential ends, close to corresponding communication openings (41a) of the nth communication opening group, of communication openings (41a) of an (n-1)th communication opening group are opposite to and in communication with an (n-1)th gas outlet group, wherein 1<n≤N.
